# EUROPEAN PATENT APPLICATION

(11) **EP 2 631 275 A1**
(43) Date of publication of application: **28.08.2013**
(21) Application number: 11834143.7
(22) Date of filing: 15.09.2011
(51) Int. Cl.: C08L 83/07, C08L 83/05, C08K 5/057, C08K 5/5435, C09K 3/10, H01L 23/29, H01L 23/31, H01L 33/56

(54) **ENCAPSULATING AGENT FOR OPTICAL SEMICONDUCTOR DEVICES, AND OPTICAL SEMICONDUCTOR DEVICE USING SAME**

(30) Priority: 19.10.2010 JP 2010234737
(71) Applicant: Sekisui Chemical Co., Ltd., Osaka-shi, Osaka 530-8565 (JP)
(72) Inventor: TANIKAWA, Mitsuru, Mishima-gun Osaka 618-0021 (JP); WATANABE, Takashi, Mishima-gun Osaka 618-0021 (JP); INUI, Osamu, Mishima-gun Osaka 618-0021 (JP); KUNIHIRO, Yoshitaka, Mishima-gun Osaka 618-0021 (JP); YAMAZAKI, Ryosuke, Mishima-gun Osaka 618-0021 (JP); KOBAYASHI, Yusuke, Mishima-gun Osaka 618-0021 (JP)
(74) Representative: Ter Meer Steinmeister & Partner
(86) International application number: PCT/JP2011/071108
(87) International publication number: WO 2012/053301

(57) **Abstract**

Provided is an encapsulant for optical semiconductor devices, which is capable of enhancing the adhesion between a housing and the encapsulant when an optical semiconductor device is encapsulated in the housing, and which is also capable of enhancing the bonding reliability with respect to humidity. The encapsulant for optical semiconductor devices includes: a first organopolysiloxane having an alkenyl group bonded to a silicon atom and an aryl group bonded to a silicon atom, but not having a hydrogen atom bonded to a silicon atom; a second organopolysiloxane having a hydrogen atom bonded to a silicon atom and an aryl group bonded to a silicon atom; a catalyst for hydrosilylation reaction; and an organic compound having a titanium atom.

## Description

### TECHNICAL FIELD

The present invention relates to an encapsulant used for encapsulating an optical semiconductor element in an optical semiconductor device, and an optical semiconductor device using the encapsulant for optical semiconductor devices.

### BACKGROUND ART

Optical semiconductor devices such as light emitting diodes (LED) have low power consumption and a long lifetime. Furthermore, the optical semiconductor devices can be used even under a severe condition. Therefore, the optical semiconductor devices are used in wide range applications such as backlights for mobile phones, backlights for liquid crystal televisions, lamps for automobiles, lighting equipments and signboards.

If an optical semiconductor element (e.g., LED), a light emitting element that is used in an optical semiconductor device, comes into direct contact with the air, light emission properties of the optical semiconductor element are rapidly degraded by moisture in the air, suspending contaminants, or the like. Thus, the optical semiconductor element is normally placed in a package called a housing, and encapsulated in the package by an encapsulant for optical semiconductor devices.

Patent Document 1 described below discloses, as an encapsulant for optical semiconductor devices, an epoxy resin material containing a hydrogenated bisphenol A glycidyl ether, an alicyclic epoxy monomer and a latent catalyst. The epoxy resin material is cured by thermal cationic polymerization.

### Prior Art Document

### Patent Document

Patent Document 1: JP 2003-73452 A

### SUMMARY OF THE INVENTION

### PROBLEMS TO BE SOLVED BY THE INVENION

In optical semiconductor devices using a conventional encapsulant for optical semiconductor devices as described in Patent Document 1, the adhesion between a package called a housing and the encapsulant may be low, or the bonding reliability with respect to humidity may be low. If the optical semiconductor devices are used in a severe condition, for example, in such a temperature cycle that the devices are repeatedly heated and cooled, the cracking may occur in encapsulant at the interface between the package and the encapsulant, or the encapsulant may be detached from a housing material or the like.

It is an object of the present invention to provide an encapsulant for optical semiconductor devices, which is capable of enhancing the adhesion between a housing and the encapsulant when an optical semiconductor device is encapsulated in the housing, and which is also capable of enhancing the bonding reliability with respect to humidity, and an optical semiconductor device using the encapsulant for optical semiconductor devices.

A definite object of the present invention is to provide an encapsulant for optical semiconductor devices, which not only is capable of enhancing the adhesion between a housing and the encapsulant, and the bonding reliability with respect to humidity, but also is capable of ensuring that cracking or detachment is hard to occur even if the optical semiconductor device is used under a severe condition, and an optical semiconductor device using the encapsulant for optical semiconductor devices.

A further definite object of the present invention is to provide an encapsulant for optical semiconductor devices, which not only is capable of enhancing the adhesion between a housing and the encapsulant, and the bonding reliability with respect to humidity, but also has a high gas barrier property to corrosive gases, and an optical semiconductor device using the encapsulant for optical semiconductor devices.

### MEANS FOR SOLVING THE PROBLEMS

According to a broad aspect of the present invention, there is provided an encapsulant for optical semiconductor devices comprising: a first organopolysiloxane having an alkenyl group bonded to a silicon atom and an aryl group bonded to a silicon atom, but not having a hydrogen atom bonded to a silicon atom; a second organopolysiloxane having a hydrogen atom bonded to a silicon atom and an aryl group bonded to a silicon atom; a catalyst for hydrosilylation reaction; and an organic compound having a titanium atom.

The organic compound having a titanium atom is preferably tetraisopropoxy titanium, tetra-n-butoxy titanium, tetrakis(2-ethylhexyloxy) titanium or titanium isopropoxyoctylene glycolate.

The encapsulant for optical semiconductor devices according to the present invention preferably further comprises an alkoxysilane compound. The alkoxysilane compound is preferably 3-glycidyloxypropyl trimethoxysilane or 2-(3,4-epoxycyclohexyl)ethyl trimethoxysilane.

In a certain aspect of the encapsulant for optical semiconductor devices according to the present invention, the first organopolysiloxane is a first organopolysiloxane represented by the following formula (1A), the second organopolysiloxane is a second organopolysiloxane represented by the following formula (51A), and the content ratios of the aryl groups determined from the following formula (X) in the first organopolysiloxane and the second organopolysiloxane each are 30 mol% or more and 70 mol% or less.

[Formula 1]

**(R1R2R3SiO_{1/2})ₐ(R4R5SiO_{2/2})_{b}(R6SiO_{3/2})_{c}** **··· Formula (1A)**

In the above formula (1A), a, b and c satisfy a / (a + b + c) = 0 to 0.50, b / (a + b + c) = 0.40 to 1.0 and c / (a + b + c) = 0 to 0.50, at least one of R1 to R6 represents a phenyl group, at least one of R1 to R6 represents an alkenyl group, and R1 to R6 other than phenyl and alkenyl groups represent a hydrocarbon group having 1 to 8 carbon atoms.

[Formula 2]

**(R51R52R53SiO_{1/2})ₚ(R54R55SiO_{2/2})_{q}(R56SiO_{3/2})ᵣ** **··· Formula (51A)**

In the above formula (51A), p, q and r satisfy p / (p + q + r) = 0.05 to 0.50, q / (p + q + r) = 0.05 to 0.50 and r / (p + q + r) = 0.20 to 0.80, at least one of R51 to R56 represents a phenyl group, at least one of R51 to R56 represents a hydrogen atom bonded directly to a silicon atom, and R51 to R56 other than a phenyl group and a hydrogen atom bonded directly to a silicon atom represent a hydrocarbon group having 1 to 8 carbon atoms.

Content ratio of aryl groups (mol%) = (average number of aryl groups contained per molecule of the first organopolysiloxane or the second organopolysiloxane x molecular weight of aryl group / number average molecular weight of the first organopolysiloxane or the second organopolysiloxane) x 100 ...formula (X)

The optical semiconductor device according to the present invention comprises: a housing; an optical semiconductor element placed in the housing; and the encapsulant for optical semiconductor devices, which is provided to encapsulate the optical semiconductor element in the housing, and configured in accordance with the present invention.

### EFFECT OF THE INVENTION

An encapsulant for optical semiconductor devices according to the present invention includes: a first organopolysiloxane having an alkenyl group bonded to a silicon atom and an aryl group bonded to a silicon atom, but not having a hydrogen atom bonded to a silicon atom; a second organopolysiloxane having a hydrogen atom bonded to a silicon atom and an aryl group bonded to a silicon atom; a catalyst for hydrosilylation reaction; and an organic compound having a titanium atom, and is therefore capable of enhancing the adhesion between a housing and the encapsulant when an optical semiconductor device is encapsulated in the housing, and also capable of enhancing the bonding reliability with respect to humidity.

### BRIEF DESCRIPTION OF DRAWINGS

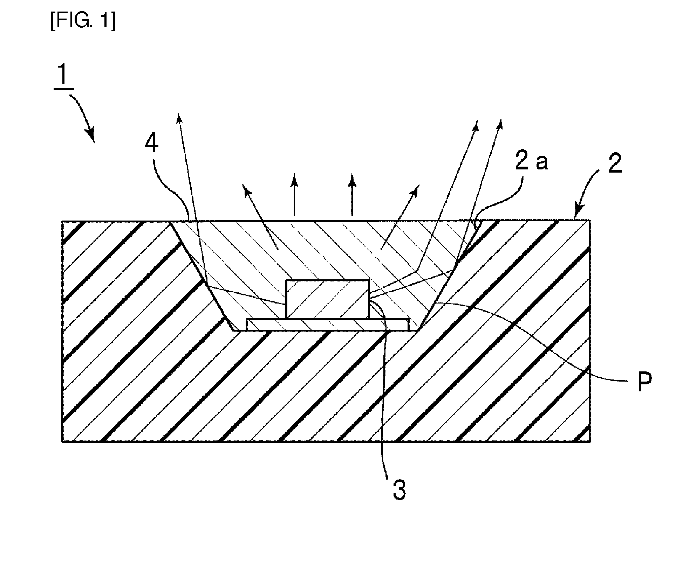

Fig. 1 is a front sectional view showing an optical semiconductor device according to one embodiment of the present invention.

### MODE(S) FOR CARRYIG OUT THE INVENTION

Details of the present invention will be described below.

An encapsulant for optical semiconductor devices according to the present invention includes: a first organopolysiloxane; a second organopolysiloxane; a catalyst for hydrosilylation reaction; and an organic compound having a titanium atom. The first organopolysiloxane does not have a hydrogen atom bonded to a silicon atom, and has an alkenyl group bonded to a silicon atom and an aryl group bonded to a silicon atom. The second organopolysiloxane has a hydrogen atom bonded to a silicon atom and an aryl group bonded to a silicon atom.

An optical semiconductor element is normally placed in a package called a housing, and encapsulated in the package by an encapsulant for optical semiconductor devices. Employment of the constitution described above can enhance the adhesion between the package called a housing and the encapsulant, and also enhance the bonding reliability with respect to humidity. In an optical semiconductor device using the encapsulant for optical semiconductor devices according to the present invention, the bonding reliability between the package and the encapsulant is high even if the device is exposed under high-humidity conditions. Further, employment of the constitution described above can ensure that cracking or detachment is hard to occur in the encapsulant even if the optical semiconductor device is used under a severe condition.

For reflecting light that arrives at the back surface side of a light emitting element, an electrode plated with silver may be formed on the back surface of the light emitting element. If cracking occurs in the encapsulant, or the encapsulant is detached from a housing material, the electrode plated with silver may be exposed to the air. In this case, plated silver may be discolored by a corrosive gas existing in the air, such as a hydrogen sulfide gas or a sulfurous acid gas. There is such a problem that when the electrode is discolored, the reflectivity decreases, so that the brightness of light emitted by the light emitting element is reduced.

In contrast, by employment of the above-described constitution in the present invention, the encapsulant has a high gas barrier property to corrosive gases.

The first organopolysiloxane is preferably a first organopolysiloxane represented by the formula (1A) from the viewpoint of obtaining an encapsulant that is further excellent in gas barrier property. The second organopolysiloxane is preferably a second organopolysiloxane represented by the formula (51A) from the viewpoint of obtaining an encapsulant that is further excellent in gas barrier property.

The content ratios of the aryl groups determined from the following formula (X) in the first organopolysiloxane and the second organopolysiloxane each are preferably 30 mol% or more, more preferably 35 mol% or more, and preferably 70 mol% or less, more preferably 65 mol% or less, from the viewpoint of further enhancing the gas barrier property of the encapsulant. When the content ratio of aryl groups is not less than the above-described lower limit and not more than the above-described upper limit, the gas barrier property is further enhanced, and detachment of the encapsulant is hard to occur.

Content ratio of aryl groups (mol%) = (average number of aryl groups contained per molecule of the first organopolysiloxane or the second organopolysiloxane x molecular weight of aryl group / number average molecular weight of the first organopolysiloxane or the second organopolysiloxane) x 100 ...formula (X).

### (First organopolysiloxane)

The first organopolysiloxane contained in the encapsulant for optical semiconductor devices according to the present invention does not have a hydrogen atom bonded to a silicon atom, and has an alkenyl group bonded to a silicon atom and an aryl group bonded to a silicon atom. As the first organopolysiloxane, an organopolysiloxane having a hydrogen atom bonded to a silicon atom is excluded. The first organopolysiloxane does not have a hydrogen atom bonded to a silicon atom, and is therefore different from the second organopolysiloxane. The alkenyl group and aryl group are each bonded directly to a silicon atom. A carbon atom in the carbon-carbon double bond in the alkenyl group may be bonded to a silicon atom, or a carbon atom different from the carbon atom in the carbon-carbon double bond in the alkenyl group may be bonded to a silicon atom. Examples of the aryl group include an unsubstituted phenyl group and a substituted phenyl group.

The first organopolysiloxane is preferably a first organopolysiloxane represented by the following formula (1A) from the viewpoint of obtaining an encapsulant that is further excellent in gas barrier property. As the first organopolysiloxane described above, however, a first organopolysiloxane other than the first organopolysiloxane represented by the following formula (1A) may be used. The first organopolysiloxane described above may be used alone, or in combination of two or more kinds.

[Formula 3]

**(R1R2R3SiO_{1/2})ₐ(R4R5SiO_{2/2})_{b}(R6SiO_{3/2})_{c}** **··· Formula (1A)**

In the above formula (1A), a, b and c satisfy a / (a + b + c) = 0 to 0.50, b / (a + b + c) = 0.40 to 1.0 and c / (a + b + c) = 0 to 0.50, at least one of R1 to R6 represents a phenyl group, at least one of R1 to R6 represents an alkenyl group, and R1 to R6 other than phenyl and alkenyl groups represent a hydrocarbon group having 1 to 8 carbon atoms. In the above formula (1A), a structural unit represented by (R4R5SiO_{2/2}) and a structural unit represented by (R6SiO_{3/2}) may each have an alkoxy group, or have a hydroxy group.

The above formula (1A) shows an average composition formula. The hydrocarbon group in the above formula (1A) may be linear or branched. R1 to R6 in the above formula (1A) may be the same or different.

In the above formula (1A), an oxygen atom moiety in the structural unit represented by (R4R5SiO_{2/2}) and an oxygen atom moiety in the structural unit represented by (R6SiO_{3/2}) each show an oxygen atom moiety forming a siloxane bond, an oxygen atom moiety of an alkoxy group, or an oxygen atom moiety of a hydroxy group.

Generally, in each structural unit in the above formula (1A), the content of the alkoxy group is low, and further the content of the hydroxy group is also low. This is because generally, when an organic silicon compound such as an alkoxysilane compound is hydrolyzed and subjected to polycondensation for obtaining a first organopolysiloxane, many of alkoxy groups and hydroxy groups are converted into a partial backbone of the siloxane bond. That is, many of oxygen atoms of the alkoxy group and oxygen atoms of the hydroxy group are converted into oxygen atoms that form the siloxane bond. When each structural unit in the above formula (1A) has an alkoxy group or a hydroxy group, it is shown that an unreacted alkoxy group or hydroxy group, which has not been converted into a partial backbone of the siloxane slightly remains. The same holds true for a case where each structural unit in the formula (51A) described later has an alkoxy group or a hydroxy group.

Examples of the alkenyl group in the above formula (1A) include a vinyl group, an allyl group, a butenyl group, a pentenyl group, a hexenyl group and the like. The alkenyl group in the first organopolysiloxane and the alkenyl group in the above formula (1A) are preferably a vinyl group or an allyl group, more preferably a vinyl group, from the viewpoint of further enhancing the gas barrier property.

The hydrocarbon group having 1 to 8 carbon atoms in the above formula (1A) is not particularly limited, and examples thereof include a methyl group, an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group and a cyclohexyl group.

The content ratio of the aryl group determined from the following formula (X1) in the first organopolysiloxane represented by the above formula (1A) is preferably 30 mol% or more and preferably 70 mol% or less. When the content ratio of the aryl group is 30 mol% or more, the gas barrier property is further enhanced. When the content ratio of the aryl group is 70 mol% or less, detachment of the encapsulant is hard to occur. The content ratio of the aryl group is more preferably 35 mol% or more from the viewpoint of further enhancing the gas barrier property. The content ratio of the aryl group is more preferably 65 mol% or less from the viewpoint of ensuring that detachment is further hard to occur.

Content ratio of aryl groups (mol%) = (average number of aryl groups contained per molecule of first organopolysiloxane of which average composition formula is represented by the above formula (1A) x molecular weight of aryl group / number average molecular weight of first organopolysiloxane of which average composition formula is represented by the above formula (1A)) x 100 ...formula (X1).

The aryl group in the above formula (X1) shows a phenyl group, and the content ratio of the aryl group shows the content ratio of the phenyl group.

The first organopolysiloxane preferably contains a diphenylsiloxane structural unit in which two phenyl groups are bonded to one silicon atom. In 100 mol% of the total siloxane structural units of the first organopolysiloxane, the ratio of the diphenylsiloxane structural unit in which two phenyl groups are bonded to one silicon atom is preferably 5 mol% or more, more preferably 10 mol% or more, further preferably 25 mol% or more, especially preferably 30 mol% or more. As the ratio of the diphenylsiloxane structural unit increases, or when the ratio of the diphenylsiloxane structural unit is 30 mol% or more, the dispensation property of the encapsulant is improved, and also the brightness of light extracted from a plurality of optical semiconductor devices becomes high. The ratio of the diphenylsiloxane structural unit is most preferably 40 mol% or more, and preferably 60 mol% or less. When the ratio of the diphenylsiloxane structural unit is not more than the above-described upper limit, the dispensation property of the encapsulant is improved, and the brightness of light extracted from the semiconductor device becomes higher.

The diphenylsiloxane structural unit is preferably a structural unit represented by the following formula (1-b1). In the structural unit represented by the following formula (1-b1), the terminal oxygen atom generally forms a siloxane bond with an adjacent silicon atom, and shares an oxygen atom with an adjacent structural unit. Therefore, one terminal oxygen atom is expressed as "O_{1/2}".

[Formula 4]

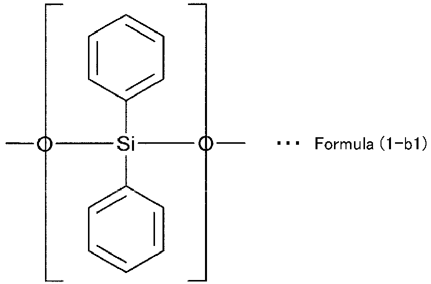

In the above formula (1A), the structural units represented by (R4R5SiO_{2/2}) each preferably include a structural unit represented by the above formula (1-b1). The structural unit represented by (R4R5SiO_{2/2}) may include only a structural unit represented by the above formula (1-b1), or may include a structural unit represented by the above formula (1-b1) and a structural unit other than the structural unit represented by the above formula (1-b1).

In the first organopolysiloxane represented by the above formula (1A), the structural unit represented by (R4R5SiO_{2/2}) (hereinafter, also referred to as a bifunctional structural unit) may include a structure represented by the following formula (1-2), i.e., a structure in which one of oxygen atoms bonded to a silicon atom in the bifunctional structural unit forms a hydroxy group or an alkoxy group.

(R4R5SiXO_{1/2}) ...formula (1-2)

The structural unit represented by (R4R5SiO_{2/2}) may include a part, surrounded by a dashed line, of a structural unit represented by the following formula (1-b), and further include a part, surrounded by a dashed line, of a structural unit represented by the following formula (1-2-b). That is, a structural unit, which has groups represented by R4 and R5 and in which an alkoxy group or a hydroxy group remains at the terminal, is also included in the structural unit represented by (R4R5SiO_{2/2}). Specifically, when the alkoxy group is converted into a partial backbone of the siloxane bond, the structural unit represented by (R4R5SiO_{2/2}) shows a part, surrounded by a dashed line, of the structural unit represented by the following formula (1-b). When an unreacted alkoxy group remains, or when an alkoxy group is converted into a hydroxy group, the structural unit having a remaining alkoxy group or a remaining hydroxy group and represented by (R4R5SiO_{2/2}) shows a part, surrounded by a dashed line, of the structural unit represented by the following formula (1-2-b).

[Formula 5]

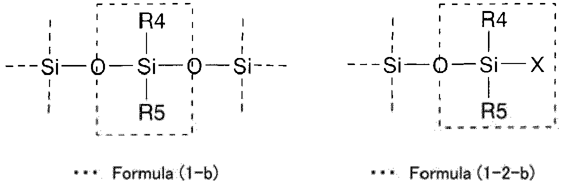

In the above formulae (1-2) and (1-2-b), X represents OH or OR, and OR represents a linear or branched alkoxy group having 1 to 4 carbon atoms. R4 and R5 in the above formulae (1-b), (1-2) and (1-2-b) are groups similar to R4 and R5 in the above formula (1A).
In the first organopolysiloxane represented by the above formula (1A), the structural unit represented by (R6SiO_{3/2}) (hereinafter, referred to as a trifunctional structural unit) may include a structure represented by the following formula (1-3) or the following formula (1-4), i.e., a structure in which two of oxygen atoms bonded to a silicon atom in the trifunctional structural unit each form a hydroxy group or an alkoxy group, or a structure in which one of oxygen atoms bonded to a silicon atom in the trifunctional structural unit forms a hydroxy group or an alkoxy group.

(R6SiX₂O_{1/2}) ...formula (1-3)

(R6SiXO_{2/2}) ...formula (1-4)

The structural unit represented by (R6SiO_{3/2}) may include a part, surrounded by a dashed line, of the structural unit represented by the following formula (1-c), and further include a part, surrounded by a dashed line, of a structural unit represented by the following formula (1-3-c) or the following formula (1-4-c). That is, a structural unit, which has a group represented by R6 and in which an alkoxy group or a hydroxy group remains at the terminal, is also included in the structural unit represented by (R6SiO_{3/2}).

[Formula 6]

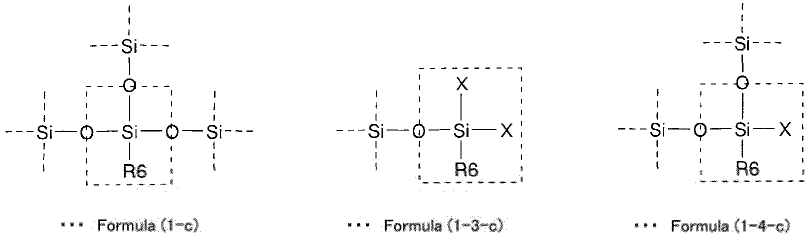

In the above formulae (1-3), (1-3-c), (1-4) and (1-4-c), X represents OH or OR, and OR represents a linear or branched alkoxy group having 1 to 4 carbon atoms. R6 in the above formulae (1-c), (1-3), (1-3-c), (1-4) and (1-4-c) is a group similar to R6 in the above formula (1A).

In the above formulae (1-b) and (1-c), the above formulae (1-2) to (1-4), and the above formulae (1-2-b), (1-3-c) and (1-4-c), the linear or branched alkoxy group having 1 to 4 carbon atoms is not particularly limited, and examples thereof include a methoxy group, an ethoxy group, a n-propoxy group, a n-butoxy group, an isopropoxy group, an isobutoxy group, a sec-butoxy group and a t-butoxy group.

In the above formula (1A), the lower limit of a / (a + b + c) is 0, and the upper limit thereof is 0.50. When a / (a + b + c) satisfies the above-described upper limit, the heat resistance of the encapsulant can be further enhanced, and detachment of the encapsulant can be further suppressed. In the above formula (1A), the upper limit of a / (a + b + c) is preferably 0.45, more preferably 0.40. When a is 0, and a / (a + b + c) is 0, the structural unit of (R1R2R3SiO_{1/2}) does not exist in the above formula (1A).

In the above formula (1A), the lower limit of b / (a + b + c) is 0.40, and the upper limit thereof is 1.0. When b / (a + b + c) satisfies the above-described lower limit, a cured product of the encapsulant does not become too hard, and cracking is hard to occur in the encapsulant. b (a + b + c) satisfies the above-described upper limit, and the structural unit of (R4R5SiO_{2/2}) exists, so that the gas barrier property of the encapsulant is further enhanced. In the above formula (1A), the lower limit of b / (a + b + c) is preferably 0.50.

In the above formula (1A), the lower limit of c / (a + b + c) is 0, and the upper limit thereof is 0.50. When c / (a + b + c) satisfies the above-described upper limit, a proper viscosity as the encapsulant is easily maintained, so that the adhesion can be further enhanced. In the above formula (1A), the upper limit of c / (a + b + c) is preferably 0.45, more preferably 0.40, further preferably 0.35. When c is 0, and c / (a + b + c) is 0, the structural unit of (R6SiO_{3/2}) does not exist in the above formula (1A).

c / (a + b + c) in the above formula (1A) is preferably 0. That is, the first organopolysiloxane represented by the above formula (1A) is preferably a first organopolysiloxane represented by the following formula (1Aa). Consequently, cracking is further hard to occur in the encapsulant, and the encapsulant is further hard to be detached from a housing material or the like.

[Formula 7]

**(R1R2R3SiO_{1/2})ₐ(R4R5SiO_{2/2})_{b}** **··· Formula (1Aa)**

In the above formula (1Aa), a and b satisfy a / (a + b) = 0 to 0.50 and b / (a + b) = 0.50 to 1.0, at least one of R1 to R5 represents a phenyl group, at least one of R1 to R5 represents an alkenyl group, and R1 to R6 other than phenyl and alkenyl groups represent a hydrocarbon group having 1 to 8 carbon atoms.

In the above formula (1Aa), the upper limit of a / (a + b) is preferably 0.45, more preferably 0.40. In the above formula (1Aa), the lower limit of b / (a + b) is preferably 0.55, more preferably 0.60.

When for the first organopolysiloxane, ²⁹Si-nuclear magnetic resonance analysis (hereinafter referred to as NMR) is performed using tetramethylsilane (hereinafter referred to as TMS) as the reference, a peak corresponding to the structural unit represented by (R1R2R3SiO_{1/2})ₐ in the above formula (1A) appears at around +10 to -5 ppm, peaks corresponding to the structural unit represented by (R4R5SiO_{2/2})_{b} in the above formula (1A) and the bifunctional structural unit in the above formula (1-2) appear at around -10 to -50 ppm, and peaks corresponding to the structural unit represented by (R6SiO_{3/2})_{c} in the above formula (1A) and the trifunctional structural units in the above formula (1-3) and the above formula (1-4) appear at around -50 to - 80 ppm, although there is a slight variation depending on the kind of a substituent.

Therefore, the ratio of the structural units in the above formula (1A) can be determined by measuring ²⁹Si-NMR, and comparing the peak areas of signals with one another.

However, if structural units in the above formula (1A) cannot be identified in the measurement of ²⁹Si-NMR using TMS as the reference, the ratios of the structural units in the above formula (1A) can be identified by using not only the result of the measurement of ²⁹Si-NMR but also the result of the measurement of ¹H-NMR as necessary.

### (Second organopolysiloxane)

The second organopolysiloxane contained in the encapsulant for optical semiconductor devices according to the present invention has a hydrogen atom bonded to a silicon atom and an aryl group bonded to a silicon atom. The hydrogen group and aryl group are each bonded directly to a silicon atom. Examples of the aryl group include an unsubstituted phenyl group and a substituted phenyl group.

The second organopolysiloxane is preferably a second organopolysiloxane represented by the following formula (51A) from the viewpoint of obtaining an encapsulant that is further excellent in gas barrier property. As the second organopolysiloxane described above, however, a second organopolysiloxane other than the second organopolysiloxane represented by the following formula (51A) may be used. The second organopolysiloxane described above may be used alone, or in combination of two or more kinds.

[Formula 8]

**(R51R52R53SiO_{1/2})ₚ(R54R55SiO_{2/2})_{q}(R56SiO_{3/2})ᵣ** **··· Formula (51A)**

In the above formula (51A), p, q and r satisfy p / (p + q + r) = 0.05 to 0.50, q / (p + q + r) = 0.05 to 0.50 and r / (p + q + r) = 0.20 to 0.80, at least one of R51 to R56 represents a phenyl group, at least one of R51 to R56 represents a hydrogen atom bonded directly to a silicon atom, and R51 to R56 other than a phenyl group and a hydrogen group bonded directly to a silicon atom represent a hydrocarbon group having 1 to 8 carbon atoms. In the above formula (51A), a structural unit represented by (R54R55SiO_{2/2}) and a structural unit represented by (R56SiO_{3/2}) may each have an alkoxy group, or have a hydroxy group.

The above formula (51A) shows an average composition formula. The hydrocarbon group in the above formula (51A) may be linear or branched. R51 to R56 in the above formula (51A) may be the same or different.

In the above formula (51A), an oxygen atom moiety in the structural unit represented by (R54R55SiO_{2/2}) and an oxygen atom moiety in the structural unit represented by (R56SiO_{3/2}) each show an oxygen atom moiety forming a siloxane bond, an oxygen atom moiety of an alkoxy group, or an oxygen atom moiety of a hydroxy group.

The hydrocarbon group having 1 to 8 carbon atoms in the above formula (51A) is not particularly limited, and examples thereof include a methyl group, an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group, a vinyl group and an allyl group.

The content ratio of the aryl group determined from the following formula (X51) in the second organopolysiloxane represented by the above formula (51A) is preferably 30 mol% or more and preferably 70 mol% or less. When the content ratio of the aryl group is 30 mol% or more, the gas barrier property is further enhanced. When the content ratio of the aryl group is 70 mol% or less, detachment of the encapsulant is hard to occur. The content ratio of the aryl group is more preferably 35 mol% or more from the viewpoint of further enhancing the gas barrier property. The content ratio of the aryl group is more preferably 65 mol% or less from the viewpoint of ensuring that detachment is further hard to occur.

Content ratio of aryl groups (mol%) = (average number of aryl groups contained per molecule of second organopolysiloxane of which average composition formula is represented by the above formula (51A) x molecular weight of aryl group / number average molecular weight of second organopolysiloxane of which average composition formula is represented by the above formula (51A)) x 100 ...formula (X51).

The aryl group in the above formula (X51) shows a phenyl group, and the content ratio of the aryl group shows the content ratio of the phenyl group.
The second organopolysiloxane preferably includes a structural unit represented by the following formula (51-a) from the viewpoint of enhancing the curability of the encapsulant and further suppressing cracking and detachment in the heat cycle. In the structural unit represented by the following formula (51-a), the terminal oxygen atom generally forms a siloxane bond with an adjacent silicon atom, and shares an oxygen atom with an adjacent structural unit. Therefore, one terminal oxygen atom is expressed as "O_{1/2}".

[Formula 9]

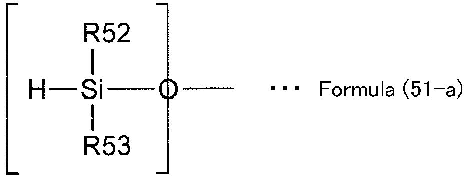

In the above formula (51-a), R52 and R53 each represent a hydrogen atom, a phenyl group or a hydrocarbon group having 1 to 8 carbon atoms. R52 and R53 each preferably represent a phenyl group or a hydrocarbon group having 1 to 8 carbon atoms.

Structural units represented by (R51R52R53SiO_{1/2}) in the above formula (51A) each preferably include a structural unit in which R51 represents a hydrogen atom bonded to a silicon atom, and R52 and R53 represent a phenyl group or a hydrocarbon group having 1 to 8 carbon atoms, from the viewpoint of enhancing the curability of the encapsulant and further suppressing cracking and detachment in the heat cycle.

That is, in the above formula (51A), the structural unit represented by (R51R52R53SiO_{1/2}) preferably includes the structural unit represented by the above formula (51-a). The structural unit represented by (R51R52R53SiO_{1/2}) may include only the structural unit represented by the above formula (51-a), or may include the structural unit represented by the above formula (51-a) and a structural unit other than the structural unit represented by the above formula (51-a).

In 100 mol% of the total siloxane structural units of the second organopolysiloxane, the ratio of the structural unit represented by the above formula (51-a) is preferably 5 mol% or more, more preferably 10 mol% or more, and preferably 50 mol% or less, more preferably 45 mol% or less, from the viewpoint of enhancing the curability of the encapsulant and further suppressing cracking and detachment in the heat cycle.

In 100 mol% of the total structural units in the above formula (51A), the ratio of the structural unit in which R51 represents a hydrogen atom bonded to a silicon atom, and R52 and R53 represent a hydrogen atom, a phenyl group or a hydrocarbon group having 1 to 8 carbon atoms (structural unit represented by the above formula (51-a)) is preferably 5 mol% or more, more preferably 10 mol% or more, and preferably 50 mol% or less, more preferably 45 mol% or less.

The second organopolysiloxane preferably contains a diphenylsiloxane structural unit in which two phenyl groups are bonded to one silicon atom. In 100 mol% of the total siloxane structural units of the second organopolysiloxane, the ratio of the diphenylsiloxane structural unit in which two phenyl groups are bonded to one silicon atom is preferably 5 mol% or more, more preferably 10 mol% or more, further preferably 20 mol% or more. As the ratio of the diphenylsiloxane structural unit increases, or when the ratio of the diphenylsiloxane structural unit is 20 mol% or more, the dispensation property of the encapsulant is improved, and also the brightness of light extracted from a plurality of optical semiconductor devices becomes high. The ratio of the diphenylsiloxane structural unit is preferably 60 mol% or less. When the ratio of the diphenylsiloxane structural unit is not more than the above-described upper limit, the dispensation property of the encapsulant is improved, and the brightness of light extracted from the semiconductor device becomes higher.

The diphenylsiloxane structural unit is preferably a structural unit represented by the following formula (51-b1). In the structural unit represented by the following formula (51-b1), the terminal oxygen atom generally forms a siloxane bond with an adjacent silicon atom, and shares an oxygen atom with an adjacent structural unit. Therefore, one terminal oxygen atom is expressed as "O_{1/2}".

[Formula 10]

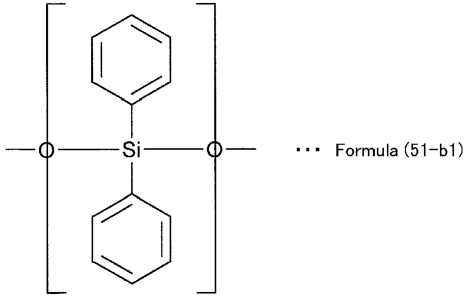

In the above formula (51A), structural units represented by (R4R5SiO_{2/2}) each preferably include the structural unit represented by the above formula (51-b1). The structural unit represented by (R4R5SiO_{2/2}) may include only the structural unit represented by the above formula (51-b1), or may include the structural unit represented by the above formula (51-b1) and a structural unit other than the structural unit represented by the above formula (51-b1).

In the second organopolysiloxane represented by the above formula (51A), the structural unit represented by (R54R55SiO_{2/2}) (hereinafter, also referred to as a bifunctional structural unit) may include a structure represented by the following formula (51-2), i.e., a structure in which one of oxygen atoms bonded to a silicon atom in the bifunctional structural unit forms a hydroxy group or an alkoxy group.

(R54R55SiXO_{1/2}) ...formula (51-2)

The structural unit represented by (R54R55SiO_{2/2}) may include a part, surrounded by a dashed line, of a structural unit represented by the following formula (51-b), and further include a part, surrounded by a dashed line, of a structural unit represented by the following formula (51-2-b). That is, a structural unit, which has groups represented by R54 and R55 and in which an alkoxy group or a hydroxy group remains at the terminal, is also included in the structural unit represented by (R54R55SiO_{2/2}).

[Formula 11]

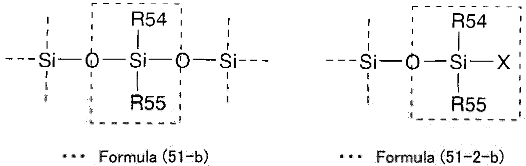

In the above formulae (51-2) and (51-2-b), X represents OH or OR, and OR represents a linear or branched alkoxy group having 1 to 4 carbon atoms. R54 and R55 in the above formulae (51-b), (51-2) and (51-2-b) are groups similar to R54 and R55 in the above formula (51A).

In the second organopolysiloxane represented by the above formula (51A), the structural unit represented by (R56SiO_{3/2}) (hereinafter, referred to as a trifunctional structural unit) may include a structure represented by the following formula (51-3) or the following formula (51-4), i.e., a structure in which two of oxygen atoms bonded to a silicon atom in the trifunctional structural unit each form a hydroxy group or an alkoxy group, or a structure in which one of oxygen atoms bonded to a silicon atom in the trifunctional structural unit forms a hydroxy group or an alkoxy group.

(R5 6SiX₂O_{1/2}) ... formula (51-3)

(R56SiXO_{2/2}) ...formula (51-4)

The structural unit represented by (R56SiO_{3/2}) may include a part, surrounded by a dashed line, of a structural unit represented by the following formula (51-c), and further include a part, surrounded by a dashed line, of a structural unit represented by the following formula (51-3-c) or the following formula (51-4-c). That is, a structural unit, which has a group represented by R56 and in which an alkoxy group or a hydroxy group remains at the terminal, is also included in the structural unit represented by (R56SiO_{3/2}).

[Formula 12]

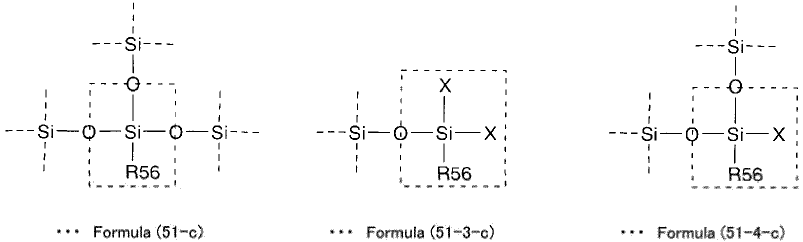

In the above formulae (51-3), (51-3-c), (51-4) and (51-4-c), X represents OH or OR, and OR represents a linear or branched alkoxy group having 1 to 4 carbon atoms. R56 in the above formulae (51-c), (51-3), (51-3-c), (51-4) and (51-4-c) is a group similar to R56 in the above formula (51A).

In the above formulae (51-b) and (51-c), the above formulae (51-2) to (51-4), and the above formulae (51-2-b), (51-3-c) and (51-4-c), the linear or branched alkoxy group having 1 to 4 carbon atoms is not particularly limited, and examples thereof include a methoxy group, an ethoxy group, a n-propoxy group, a n-butoxy group, an isopropoxy group, an isobutoxy group, a sec-butoxy group and a t-butoxy group.

In the above formula (51A), the lower limit of p / (p + q + r) is 0.05, and the upper limit thereof is 0.50. When p / (p + q + r) satisfies the above-described upper limit, the heat resistance of the encapsulant can be further enhanced, and detachment of the encapsulant can be further suppressed. In the above formula (51A), the lower limit of p / (p + q + r) is preferably 0.10, and the upper limit thereof is more preferably 0.45.

In the above formula (51A), the lower limit of q / (p + q + r) is 0.05, and the upper limit thereof is 0.50. When q / (p + q + r) satisfies the above-described lower limit, a cured product of the encapsulant does not become too hard, and cracking is hard to occur in the encapsulant. When q / (p + q + r) satisfies the above-described upper limit, the gas barrier property of the encapsulant is further enhanced. In the above formula (51A), the lower limit of q / (p + q + r) is preferably 0.10, and the upper limit thereof is more preferably 0.45.

In the above formula (51A), the lower limit of r / (p + q + r) is 0.20, and the upper limit thereof is 0.80. When r / (p + q + r) satisfies the above-described lower limit, the hardness of the encapsulant is increased, so that scratches and deposition of contaminants can be prevented, and the heat resistance of the encapsulant is enhanced, so that the thickness of the cured product of the encapsulant is hard to decrease under a high-temperature condition. When r / (p + q + r) satisfies the above-described upper limit, a proper viscosity as the encapsulant is easily maintained, so that the adhesion can be further enhanced.

When for the second organopolysiloxane, ²⁹Si-nuclear magnetic resonance analysis (hereinafter referred to as NMR) is performed using tetramethylsilane (hereinafter referred to as TMS) as the reference, a peak corresponding to the structural unit represented by (R51R52R53SiO_{1/2})ₚ in the above formula (51A) appears at around +10 to -5 ppm, peaks corresponding to the structural unit represented by (R54R55SiO_{2/2})_{q} in the above formula (51A) and the bifunctional structural unit in the above formula (51-2) appear at around -10 to -50 ppm, and peaks corresponding to the structural unit represented by (R56SiO_{3/2})ᵣ in the above formula (51A) and the trifunctional structural units in the above formula (51-3) and the above formula (51-4) appear at around -50 to -80 ppm, although there is a slight variation depending on the kind of a substituent.

Therefore, the ratio of the structural units in the above formula (51A) can be determined by measuring ²⁹Si-NMR, and comparing the peak areas of signals with one another.

However, if structural units in the above formula (51A) cannot be identified in the measurement of ²⁹Si-NMR using TMS as the reference, the ratios of the structural units in the above formula (51A) can be identified by using not only the result of the measurement of ²⁹Si-NMR but also the result of the measurement of ¹H-NMR as necessary.

The content of the second organopolysiloxane is preferably 10 parts by weight or more and 400 parts by weight or less based on 100 parts by weight of the first organopolysiloxane. When the contents of the first and second organopolysiloxanes fall within this range, an encapsulant that is further excellent in gas barrier property can be obtained. The lower limit of the content of the second organopolysiloxane is more preferably 30 parts by weight, further preferably 50 parts by weight, and the upper limit thereof is more preferably 300 parts by weight, further preferably 200 parts by weight, based on 100 parts by weight of the first organopolysiloxane, from the viewpoint of obtaining an encapsulant that is further excellent in gas barrier property.

### (Other natures of first and second organopolysiloxanes and method for synthesis thereof)

The lower limit of the content of alkoxy groups in the first and second organopolysiloxanes is preferably 0.5 mol%, more preferably 1 mol%, and the upper limit thereof is preferably 10 mol%, more preferably 5 mol%. When the content of alkoxy groups falls within the above-described preferred range, the adhesion of the encapsulant can be enhanced.

When the content of alkoxy groups satisfies the above-described preferred lower limit, the adhesion of the encapsulant can be enhanced. When the content of alkoxy groups satisfies the above-described preferred upper limit, the storage stability of the first and second organopolysiloxanes and the encapsulant is enhanced, and the heat resistance of the encapsulant is further enhanced.

The content of the alkoxy group refers to an amount of the alkoxy group contained in the average composition of the first and second organopolysiloxanes.

The first and second organopolysiloxanes preferably contain no silanol group. When the first and second organopolysiloxanes contain no silanol group, the storage stability of the first and second organopolysiloxanes and the encapsulant is enhanced. The silanol group can be reduced by heating under vacuum. The content of the silanol group can be measured using infrared spectroscopy.

The lower limit of the number average molecular weight (Mn) of the first and second organopolysiloxanes is preferably 500, more preferably 800, further preferably 1000, and the upper limit thereof is preferably 50000, more preferably 15000. When the number average molecular weight satisfies the above-described preferred lower limit, volatile components are reduced during heat curing, and the thickness of a cured product of the encapsulant is hard to decrease under a high-temperature condition. When the number average molecular weight satisfies the above-described preferred upper limit, viscosity adjustment is easy.

The number average molecular weight (Mn) is a value determined with polystyrene as a standard substance using gel permeation chromatography (GPC). The number average molecular weight (Mn) refers to a value measured by using a measuring apparatus manufactured by Waters Corporation (column: two pieces of Shodex GPC LF-804 (length: 300 mm) manufactured by SHOWA DENKO K.K.; measurement temperature: 40°C; flow rate: 1 mL/minute; solvent: tetrahydrofuran; standard substance: polystyrene).

The method for synthesis of the first and second organopolysiloxanes is not particularly limited, and examples thereof include a method in which an alkoxysilane compound is hydrolyzed and subjected to a condensation reaction, and a method in which a chlorosilane compound is hydrolyzed and condensed. Particularly, the method in which an alkoxysilane compound is hydrolyzed and condensed is preferable from the viewpoint of control of the reaction.

Examples of the method in which an alkoxysilane compound is hydrolyzed and subjected to a condensation reaction include a method in which an alkoxysilane compound is reacted in the presence of water and an acidic catalyst or a basic catalyst. A disiloxane compound may be hydrolyzed and used.

Examples of the organic silicon compound for introducing an aryl group such as a phenyl group into the first and second organopolysiloxanes include triphenylmethoxysilane, triphenylethoxysilane, diphenyldimethoxysilane, diphenyldiethoxysilane, methyl(phenyl)dimethoxysilane, phenyltrimethoxysilane and the like.

Examples of the organic silicon compound for introducing an alkenyl group into the first organopolysiloxane include vinyltrimethoxysilane, vinyltriethoxysilane, vinylmethyldimethoxysilane, methoxydimethylvinylsilane, vinyldimethylethoxysilane, 1,3-divinyl-1,1,3,3-tetramethyldisiloxane and the like.

Examples of the organic silicon compound for introducing a hydrogen atom bonded directly to a silicon atom into the second organopolysiloxane include trimethoxysilane, triethoxysilane, methyldimethoxysilane, methyldiethoxysilane, 1,1,3,3-tetramethyldisiloxane and the like.

Examples of other organic silicon compounds that can be used for obtaining the first and second organopolysiloxanes include trimethylmethoxysilane, trimethylethoxysilane, dimethyldimethoxysilane, dimethyldiethoxysilane, isopropyl(methyl)dimethoxysilane, cyclohexyl(methyl)dimethoxysilane, methyltrimethoxysilane, methyltriethoxysilane, ethyltrimethoxysilane, ethyltriethoxysilane, hexyltrimethoxysilane, octyltrimethoxysilane and the like.

Examples of the acidic catalyst include an inorganic acid, an organic acid, an acid anhydride of an inorganic acid and a derivative thereof, and an acid anhydride of an organic acid and a derivative thereof.

Examples of the inorganic acid include hydrochloric acid, phosphoric acid, boric acid and carbonic acid. Examples of the organic acid include formic acid, acetic acid, propionic acid, butyric acid, lactic acid, malic acid, tartaric acid, citric acid, oxalic acid, malonic acid, succinic acid, glutaric acid, adipic acid, fumaric acid, maleic acid and oleic acid.

Examples of the basic catalyst include a hydroxide of an alkali metal, an alkoxide of an alkali metal and a silanol compound of an alkali metal.

Examples of the hydroxide of an alkali metal include sodium hydroxide, potassium hydroxide and cesium hydroxide. Examples of the alkoxide of an alkali metal include sodium-t-butoxide, potassium-t-butoxide and cesium-t-butoxide.

Examples of the silanol compound of an alkali metal include a sodium silanolate compound, a potassium silanolate compound and a cesium silanolate compound. Particularly, a potassium-based catalyst and a cesium-based catalyst are suitable.

### (Catalyst for hydrosilylation reaction)

The catalyst for hydrosilylation reaction contained in the encapsulant for optical semiconductor devices according to the present invention is a catalyst for subjecting to a hydrosilylation reaction between an alkenyl group bonded to a silicon atom in the first organopolysiloxane and a hydrogen atom bonded to a silicon atom in the second organopolysiloxane.

As the catalyst for hydrosilylation reaction, various kinds of catalysts that allow the hydrosilylation reaction to proceed can be used. The catalyst for hydrosilylation reaction may be used alone, or in combination of two or more kinds.

Examples of the catalyst for hydrosilylation reaction include a platinum-based catalyst, a rhodium-based catalyst, a palladium-based catalyst and the like. The platinum-based catalyst is preferable because it can enhance the transparency of the encapsulant.

Examples of the platinum-based catalyst include a platinum powder, chloroplatinic acid, a platinum-alkenylsiloxane complex, a platinum-olefin complex and a platinum-carbonyl complex. Particularly, the platinum-alkenylsiloxane complex or the platinum-olefin complex is preferable.

Examples of the alkenylsiloxane in the platinum-alkenylsiloxane complex include 1,3-divinyl-1,1,3,3-tetramethyldisiloxane, 1,3,5,7-tetramethyl-1,3,5,7-tetravinylcyclotetrasiloxane and the like. Examples of the olefin in the platinum-olefin complex include an allyl ether, 1,6-heptadiene and the like.

It is preferable to add an alkenylsiloxane, an organosiloxane oligomer, an allyl ether or an olefin to the platinum-alkenylsiloxane complex or the platinum-olefin complex because the stability of the platinum-alkenylsiloxane complex and platinum-olefin complex can be improved. The alkenylsiloxane is preferably 1,3-divinyl-1,1,3,3-tetramethyldisiloxane. The organosiloxane oligomer is preferably a dimethylsiloxane oligomer. The olefin is preferably 1,6-heptadiene.

The catalyst for hydrosilylation reaction preferably contains a platinum alkenyl complex. The above-described platinum-based catalyst is preferably a mixture of a platinum alkenyl complex and a phosphorus compound. That is, the platinum-based catalyst preferably contains a platinum alkenyl complex and a phosphorus compound. The platinum alkenyl complex may be used alone, or in combination of two or more kinds.

By use of the specific first and second organopolysiloxanes in combination with the platinum-based catalyst that is a mixture of a platinum alkenyl complex and a phosphorus compound, the gas barrier property of the encapsulant can be further enhanced. Further, cracking is hard to occur in a cured encapsulant, and the cured encapsulant is hard to be detached from a housing material or the like.

Conventional encapsulants for optical semiconductor devices have such a problem that the encapsulant is discolored in a reflow process at the time of mounting on a printed board, so that the luminous intensity is reduced. In contrast, owing to employment of the above-described constitution in the present invention, i.e., use of the specific first and second organopolysiloxanes in combination with the platinum-based catalyst that is a mixture of a platinum alkenyl complex and a phosphorus compound, the encapsulant is hard to be discolored even if exposed to severe conditions of the reflow process and the like. By use of the platinum-based catalyst that is a mixture of a platinum alkenyl complex and a phosphorus compound, the transparency of the encapsulant can also be enhanced.

Examples of the phosphorus compound include triphenylphosphine, tricyclohexylphosphine, triethylphosphine and the like. The phosphorus compound is preferably triphenylphosphine from the viewpoint of obtaining an encapsulant that is further hard to be discolored even if exposed to severe conditions.

In the encapsulant, the content of the catalyst for hydrosilylation reaction is preferably 0.01 ppm or more and 1000 ppm or less in terms of the weight unit of the metal atom (platinum element when the metal atom is a platinum element). When the content of the catalyst for hydrosilylation reaction is 0.01 ppm or more, it is easy to sufficiently cure the encapsulant, and the gas barrier property of the encapsulant can be further enhanced. When the content of the catalyst for hydrosilylation reaction is 1000 ppm or less, the problem of coloring of a cured product is hard to occur. In the encapsulant, the content of the catalyst for hydrosilylation reaction is more preferably 1 ppm or more and more preferably 500 ppm or less in terms of the weight unit of the metal atom.

When the platinum-based catalyst that is a mixture of a platinum alkenyl complex and a phosphorus compound is used, the platinum catalyst contains the platinum element and the phosphorus compound at a weight ratio of preferably 0.1 : 99.9 to 99.9 : 0.1, more preferably 1 : 99 to 20 : 80.

### (Organic compound having titanium atom)

The encapsulant for optical semiconductor devices according to the present invention contains the specific first and second organopolysiloxanes and the catalyst for hydrosilylation reaction as well as an organic compound having a titanium atom (hereinafter may be abbreviated as an organic compound A), and is therefore capable of enhancing the bonding reliability between a housing and the encapsulant with respect to humidity, and capable of ensuring that cracking or detachment is hard to occur even if the optical semiconductor device is used under a severe condition. The organic compound A may be used alone, or in combination of two or more kinds.

For sufficiently dispersing the organic compound A in the encapsulant and effectively enhancing the bonding reliability between the housing and the encapsulant with respect to humidity, the organic compound having a titanium atom is preferably liquid at 25°C.

Examples of the organic compound A include compounds represented by the following formula (A).

Ti(R1)ₙ(OR2)₄₋ₙ ...formula (A)

In the above formula (2), R1 represents a phenyl group, an alkyl group having 1 to 30 carbon atoms, or a hydrocarbon group having an epoxy group and having 1 to 30 carbon atoms, R2 represents an alkyl group having 1 to 6 carbon atoms, and n represents an integer of 0 to 4. When n is 2 to 4, a plurality of R1s may be the same or different. When n is 0 to 2, a plurality of R2s may be the same or different.

When R1 in the above formula (A) is an alkyl group having 1 to 30 carbon atoms, specific examples of R1 include a methyl group, an ethyl group, a propyl group, an isopropyl group, an isobutyl group, a n-hexyl group, a cyclohexyl group, a n-octyl group, a n-decyl group and the like. The upper limit of the number of carbon atoms of this alkyl group is preferably 10, more preferably 6. In this specification, the "alkyl group" includes a cycloalkyl group.

When R1 in the above formula (A) is a hydrocarbon group having an epoxy group and having 1 to 30 carbon atoms, specific examples of R1 include a 1,2-epoxyethyl group, a 1,2-epoxypropyl group, a 2,3-epoxypropyl group, a 3,4-epoxybutyl group, a 3-glycidyloxypropyl group, a 2-(3,4-epoxycyclohexyl)ethyl group and the like. The upper limit of the number of carbon atoms of this hydrocarbon group is preferably 8, more preferably 6. In this specification, the hydrocarbon group in the "hydrocarbon group having an epoxy group and having 1 to 30 carbon atoms" is a group having, in addition to carbon atoms and hydrogen atoms, an oxygen atom originating from an epoxy group. The "hydrocarbon group having an epoxy group and having 1 to 30 carbon atoms" is, in other words, a functional group which has an epoxy group and contains an oxygen atom, 1 to 30 carbon atoms, and hydrogen atoms.

Specific Examples of R2 in the above formula (A) include a methyl group, an ethyl group, a n-propyl group, an isopropyl group, a n-butyl group, an isobutyl group and the like.

The organic compound having a titanium atom is preferably tetraisopropoxy titanium, tetra-n-butoxy titanium, tetrakis(2-ethylhexyloxy) titanium or titanium isopropoxyoctylene glycolate from the viewpoint of further enhancing the bonding reliability between the housing and the encapsulant with respect to humidity and ensuring that cracking or detachment is further hard to occur in the encapsulant even if the optical semiconductor device is used under a severe condition.

The content of the organic compound A is preferably 0.01 parts by weight or more and 5 parts by weight or less based on 100 parts by weight of the total of the first organopolysiloxane and the second organopolysiloxane. The lower limit of the content of the organic compound A based on 100 parts by weight of the total of the first organopolysiloxane and the second organopolysiloxane is more preferably 0.1 parts by weight, and the upper limit thereof is more preferably 3 parts by weight. When the content of the organic compound A is not less than the above-described lower limit, the bonding reliability between the housing and the encapsulant with respect to humidity can be further enhanced, and it can be ensured that cracking or detachment is further hard to occur in the encapsulant even if the optical semiconductor device is used under a severe condition. When the content of the organic compound A is not more than the above-described upper limit, the storage stability of the encapsulant can be further improved.

### (Alkoxysilane compound)

The encapsulant for optical semiconductor devices according to the present invention preferably includes an alkoxysilane compound. By further using an alkoxysilane compound in addition to the specific first and second organopolysiloxanes, the catalyst for hydrosilylation reaction and the organic compound having a titanium atom, the bonding reliability between the housing and the encapsulant with respect to humidity can be further enhanced, and it can be ensured that cracking or detachment is further hard to occur in the encapsulant even if the optical semiconductor device is used under a severe condition. Particularly, by use of the organic compound A in combination with the alkoxysilane compound, the bonding reliability between the housing and the encapsulant with respect to humidity is significantly enhanced. The alkoxysilane compound may be used alone, or in combination of two or more kinds.

Examples of the alkoxysilane compound include alkoxysilane compounds represented by the following formula (B).

Si(R3)ₙ(OR4)₄₋ₙ ...formula (B)

In the above formula (2), R3 represents a vinyl group, a hydrocarbon group having a (meth)acryloyl group and having 1 to 30 carbon atoms, a phenyl group, an alkyl group having 1 to 30 carbon atoms, or a hydrocarbon group having an epoxy group and having 1 to 30 carbon atoms, R4 represents an alkyl group having 1 to 6 carbon atoms, and n represents an integer of 0 to 3. When n is 2 or 3, a plurality of R3s may be the same or different. When n is 0 to 2, a plurality of R4s may be the same or different. The "(meth)acryloyl group" refers to an acryloyl group and a methacryloyl group.

When R3 in the above formula (B) is an alkyl group having 1 to 30 carbon atoms, specific examples of R3 include a methyl group, an ethyl group, a propyl group, an isopropyl group, an isobutyl group, a n-hexyl group, a cyclohexyl group, a n-octyl group, a n-decyl group and the like. The upper limit of the number of carbon atoms of this alkyl group is preferably 10, more preferably 6.

When R3 in the above formula (B) is a hydrocarbon group having an epoxy group and having 1 to 30 carbon atoms, specific examples of R3 include a 1,2-epoxyethyl group, a 1,2-epoxypropyl group, a 2,3-epoxypropyl group, a 3,4-epoxybutyl group, a 3-glycidyloxypropyl group, a 2-(3,4-epoxycyclohexyl)ethyl group and the like. The upper limit of the number of carbon atoms of this hydrocarbon group is preferably 8, more preferably 6.

Specific Examples of R4 in the above formula (B) include a methyl group, an ethyl group, a n-propyl group, an isopropyl group, a n-butyl group, an isobutyl group and the like.

The alkoxysilane compound preferably has an epoxy group, more preferably has a 3-glycidyloxyalkyl group or a 3,4-epoxycycloalkyl group, further preferably has a 3-glycidyloxypropyl group or a 3,4-epoxycyclohexyl group from the viewpoint of further enhancing the bonding reliability between the housing and the encapsulant with respect to humidity and ensuring that cracking or detachment is further hard to occur in the encapsulant even if the optical semiconductor device is used under a severe condition. The alkoxysilane compound is preferably 3-glycidyloxypropyl trimethoxysilane or 2-(3,4-epoxycyclohexyl)ethyl trimethoxysilane from the viewpoint of further enhancing the bonding reliability between the housing and the encapsulant with respect to humidity and ensuring that cracking or detachment is further hard to occur in the encapsulant even if the optical semiconductor device is used under a severe condition.

The content of the alkoxysilane compound is preferably 0.01 parts by weight or more and 5 parts by weight or less based on 100 parts by weight of the total of the first organopolysiloxane and the second organopolysiloxane. The lower limit of the content of the alkoxysilane compound based on 100 parts by weight of the total of the first organopolysiloxane and the second organopolysiloxane is more preferably 0.1 parts by weight, and the upper limit thereof is more preferably 3 parts by weight. When the content of the alkoxysilane compound is not less than the above-described lower limit, the bonding reliability between the housing and the encapsulant with respect to humidity can be further enhanced, and cracking or detachment is further hard to occur in the encapsulant even if the optical semiconductor device is used under a severe condition. When the content of the alkoxysilane compound is not more than the above-described upper limit, the storage stability of the encapsulant can be further improved.

### (Silicon oxide particles)

The encapsulant for optical semiconductor devices according to the present invention preferably further includes silicon oxide particles. By use of the silicon oxide particles, the viscosity of the encapsulant before curing can be adjusted to fall within an appropriate range without impairing the heat resistance and light resistance of a cured product of the encapsulant. Therefore, the handling property of the encapsulant can be enhanced.

The lower limit of the primary particle diameter of the silicon oxide particles is preferably 5 nm, more preferably 8 nm, and the upper limit thereof is preferably 200 nm, more preferably 150 nm. When the primary particle diameter of the silicon oxide particles satisfies the above-described preferred lower limit, the dispersibility of the silicon oxide particles is further enhanced, and the transparency of the cured product of the encapsulant is further enhanced. When the primary particle diameter of the silicon oxide particles satisfies the above-described preferred upper limit, a sufficient effect of increasing the viscosity at 25°C can be obtained, and a reduction in viscosity during temperature elevation can be suppressed.

The primary particle diameter of the silicon oxide particles is measured in the following manner. The cured product of the encapsulant for optical semiconductor devices is observed using a transmission electron microscope (trade name "JEM-2100", manufactured by JEOL Ltd.). The sizes of primary particles of 100 silicon oxide particles in the visual field are each measured, and the average value of measured values is designated as a primary particle diameter. The primary particle diameter refers to an average value of diameters of silicon oxide particles when the silicon oxide particle is spherical, and refers to an average value of longitudinal diameters of silicon oxide particles when the silicon oxide particle is nonspherical.

The lower limit of the BET specific surface area of the silicon oxide particles is preferably 30 m²/g, and the upper limit thereof is preferably 400 m²/g. When the BET specific surface area of the silicon oxide particles is 30m ²/g or more, the viscosity of the encapsulant at 25°C can be controlled to fall within a suitable range, and a reduction in viscosity during temperature elevation can be suppressed. When the BET specific surface area of the silicon oxide particles is 400 m²/g or less, coagulation of silicon oxide particles is hard to occur, so that dispersibility can be enhanced, and also the transparency of the cured product of the encapsulant can be further enhanced.

The silicon oxide particle is not particularly limited, and examples thereof include silica produced by a dry method, such as fumed silica and fused silica, and silica produced by a wet method, such as colloidal silica, sol-gel silica and precipitated silica, and the like. Particularly, fumed silica is suitably used as the silicon oxide particle from the viewpoint of obtaining an encapsulant having a reduced volatile component and having further high transparency.

Examples of the fumed silica include Aerosil 50 (specific surface area: 50 m²/g), Aerosil 90 (specific surface area: 90 m²/g), Aerosil 130 (specific surface area: 130 m²/g), Aerosil 200 (specific surface area: 200 m²/g), Aerosil 300 (specific surface area: 300 m²/g), Aerosil 380 (specific surface area: 380 m²/g) (all of which are manufactured by Nippon Aerosil Co., Ltd.) and the like.

The silicon oxide particles are preferably surface-treated with an organic silicon compound. Owing to this surface treatment, the dispersibility of the silicon oxide particles is extremely enhanced, and a reduction in viscosity by elevation of the temperature of the encapsulant before curing can be further suppressed.

The organic silicon compound is not particularly limited, and examples thereof include a silane-based compound having an alkyl group, a silicon-based compound having a siloxane backbone, such as dimethylsiloxane, a silicon-based compound having an amino group, a silicon-based compound having a (meth)acryloyl group, a silicon-based compound having an epoxy group and the like. The "(meth)acryloyl group" refers to an acryloyl group and a methacryloyl group.

The organic silicon compound used for surface treatment is preferably at least one selected from the group consisting of an organic silicon compound having a dimethylsilyl group, an organic silicon compound having a trimethylsilyl group and an organic silicon compound having a polydimethylsiloxane group from the viewpoint of further enhancing the dispersibility of the silicon oxide particles. The organic silicon compound used for surface treatment is preferably at least one of an organic silicon compound having a trimethylsilyl group and an organic silicon compound having a polydimethylsiloxane group from the viewpoint of further enhancing the dispersibility of the silicon oxide particles.

If an encapsulant, which contains first and second organopolysiloxanes having an aryl group and a fluorescent substance, is exposed to a high temperature before curing, the viscosity of the encapsulant is rapidly reduced, so that the fluorescent substance easily settles out. Therefore, if the encapsulant is exposed to a high temperature at the time of curing, the fluorescent substance is located intensively on the periphery of a light emitting element, so that light is irregularly reflected. As a result, there is such a problem that a part of light emitted from the light emitting element is lost in the cured product of the encapsulant, leading to a decrease in the amount of light extracted from the optical semiconductor device.

The encapsulant for optical semiconductor devices according to the present invention contains silicon oxide particles surface-treated with the organic silicon compound, so that the viscosity of the encapsulant at a high temperature can be kept sufficiently high even though the first and second organopolysiloxanes having an aryl group are contained. Consequently, the viscosity at the time when the encapsulant is exposed to a high temperature can be adjusted to fall within an appropriate range, and the dispersed state of the fluorescent substance in the encapsulant can be kept even.

One example of the method for surface-treating with an organic silicon compound includes a method in which silicon oxide particles are surface-treated with, for example, dichlorodimethylsilane, dimethyldimethoxysilane, hexamethyldisilazane, trimethylsilyl chloride, and trimethylmethoxysilane when an organic silicon compound having a dimethylsilyl group or an organic silicon compound having a trimethylsilyl group is used. Mention is made of a method in which silicon oxide particles are surface-treated with a compound having a silanol group at the terminal of a polydimethylsiloxane group, a cyclic siloxane, and the like when an organic silicon compound having a polydimethylsiloxane group is used.

Examples of a commercial product of silicon oxide particles surface-treated with the organic silicon compound having a dimethylsilyl group include R974 (specific surface area: 170 m²/g), R964 (specific surface area: 250 m²/g) (both of which are manufactured by Nippon Aerosil Co., Ltd.) and the like.

Examples of a commercial product of silicon oxide particles surface-treated with the organic silicon compound having a trimethylsilyl group include RX200 (specific surface area: 140 m²/g), R8200 (specific surface area: 140 m²/g) (both of which are manufactured by Nippon Aerosil Co., Ltd.) and the like.

Examples of a commercial product of silicon oxide particles surface-treated with the organic silicon compound having a polydimethylsiloxane group include RY200 (specific surface area: 120 m²/g) (manufactured by Nippon Aerosil Co., Ltd.) and the like.

The method for surface-treating silicon dioxide particles with the organic silicon compound is not particularly limited. Examples of the method include direct treatment methods such as a dry method in which silicon oxide particles are added into a mixer, and an organic silicon compound is added with stirring; a slurry method in which an organic silicon compound is added into a slurry of silicon oxide particles; and a spray method in which an organic silicon compound is sprayed after silicon oxide particles are dried; and the like. Examples of a mixer used in the dry method include a Henschel mixer, a V-type mixer and the like. In the dry method, the organic silicon compound is added directly or as an aqueous alcoholic solution, an organic solvent solution or an aqueous solution.

For obtaining silicon oxide particles surface-treated with the organic silicon compound, an integral blend method or the like may be used in which an organic silicon compound is added directly at the time of mixing silicon oxide particles and a matrix resin of the first and second organopolysiloxanes and the like when an encapsulant for optical semiconductor devices is prepared.

The content of the silicon oxide particles is preferably 0.5 parts by weight or more and 40 parts by weight or less based on 100 parts by weight of the total of the first organopolysiloxane and the second organopolysiloxane. The lower limit of the content of the silicon oxide particles based on 100 parts by weight of the total of the first organopolysiloxane and the second organopolysiloxane is more preferably 1 part by weight, and the upper limit thereof is more preferably 35 parts by weight. When the content of the silicon oxide particles satisfies the above-described lower limit, a reduction in viscosity at the time of curing can be suppressed. When the content of the silicon oxide particles satisfies the above-described upper limit, the viscosity of the encapsulant can be controlled to fall within a further appropriate range, and the transparency of the encapsulant can be further enhanced.

### (Fluorescent substance)

The encapsulant for optical semiconductor devices according to the present invention may further contain a fluorescent substance. The fluorescent substance acts so that light of a desired color can be ultimately obtained by absorbing light emitted from a light emitting element encapsulated using an encapsulant for optical semiconductor devices, and emitting fluorescence. The fluorescent substance is excited by light emitted from the light emitting element to emit fluorescence, and light of a desired color can be obtained by combination of light emitted from the light emitting element and fluorescence emitted from the fluorescent substance.

For example, when it is desired to ultimately obtain white light using an ultraviolet-ray LED chip as a light emitting element, combined use of a blue fluorescent substance, a red fluorescent substance and a green fluorescent substance is preferable. When it is desired to ultimately obtain white light using a blue LED chip as a light emitting element, combined use of a green fluorescent substance and a red fluorescent substance, or use of a yellow fluorescent substance is preferable. The fluorescent substance may be used alone, or in combination of two or more kinds.

The blue fluorescent substance is not particularly limited, and examples thereof include (Sr, Ca, Ba, Mg)₁₀(PO₄)₆Cl₂ : Eu, (Ba, Sr)MgAl₁₀O₁₇ : Eu, (Sr, Ba)₃MgSi₂O₈ : Eu and the like.

The red fluorescent substance is not particularly limited, and examples thereof include (Sr, Ca)S : Eu, (Ca, Sr)₂Si₅N₈ : Eu, CaSiN₂ : Eu, CaAlSiN₃ : Eu, Y₂O₂S : Eu, La₂O₂S : Eu, LiW₂O₈ : (Eu, Sm), (Sr, Ca, Bs, Mg)₁₀(PO₄)₈Cl₂ : (Eu, Mn), Ba₃MgSi₂O₈ : (Eu, Mn) and the like.

The green fluorescent substance is not particularly limited, and examples thereof include Y₃(Al, Ga)₅O₁₂ : Ce, SrGa₂S₄ : Eu, Ca₃Sc₂Si₃O₁₂ : Ce, SrSiON : Eu, ZnS : (Cu, Al), BaMgAl₁₀O₁₇(Eu, Mn), SrAl₂O₄ : Eu and the like.

The yellow fluorescent substance is not particularly limited, and examples thereof include Y₃Al₅O₁₂ : Ce, (Y, Gd)₃Al₅O₁₂ : Ce, Tb₃Al₅O₁₂ : Ce, CaGa₂S₄ : Eu, Sr₂SiO₄ : Eu, and the like.

Further, examples of the fluorescent substance include a perylene-based compound that is an organic fluorescent substance and the like.

The lower limit of the volume average particle diameter of the fluorescent substance is preferably 1 µm, more preferably 2 µm, and the upper limit thereof is preferably 30 µm, more preferably 25 µm.

The content of the fluorescent substance can be appropriately adjusted so as to obtain a desired color, and is not particularly limited. The content of the fluorescent substance is preferably 0.1 parts by weight or more and 40 parts by weight or less based on 100 parts by weight of the encapsulant for optical semiconductor devices according to the present invention. When the encapsulant for optical semiconductor devices according to the present invention contains a fluorescent substance, the content of the fluorescent substance is preferably 0.1 parts by weight or more and 40 parts by weight or less based on 100 parts by weight of all the components except the fluorescent substance of the encapsulant for optical semiconductor devices.

### (Other components)

The encapsulant for optical semiconductor devices according to the present invention may further contain an additive such as a dispersant, an antioxidant, an antifoaming agent, a modifier, a leveling agent, a light diffusing agent, a heat conductive filler, a flame retardant or the like as necessary.

Liquids containing one or more of the first organopolysiloxane, the second organopolysiloxane, the catalyst for hydrosilylation reaction and the organic compound A may be prepared respectively, and the liquids may be mixed just before use to prepare the encapsulant for optical semiconductor devices according to the present invention. For example, a liquid A containing the first organopolysiloxane, the catalyst for hydrosilylation reaction and the organic compound A and a liquid B containing the second organopolysiloxane may be prepared respectively, and the liquids A and B may be mixed just before use to prepare the encapsulant for optical semiconductor devices according to the present invention. As described above, by forming the first organopolysiloxane, the catalyst for hydrosilylation reaction and the organic compound A, and the second organopolysiloxane into two liquids: a first liquid and a second liquid, respectively, storage stability can be improved. When the above-described alkoxysilane compound is used, the alkoxysilane compound may be added to the first liquid, or added to the second liquid.

### (Details and applications of encapsulant for optical semiconductor devices)

The curing temperature of the encapsulant for optical semiconductor devices according to the present invention is not particularly limited. The lower limit of the curing temperature of the encapsulant for optical semiconductor devices is preferably 80°C, more preferably 100°C, and the upper limit thereof is preferably 180°C, more preferably 150°C. When the curing temperature satisfies the above-described preferred lower limit, curing of the encapsulant sufficiently proceeds. When the curing temperature satisfies the above-described preferred upper limit, heat degradation of the package is hard to occur.

A curing manner is not particularly limited, but a step-cure manner is preferably used. The step-cure manner is a method in which the encapsulant is pre-cured at a low temperature on a temporary basis, and thereafter cured at a high temperature. By use of the step-cure manner, cure shrinkage of the encapsulant can be suppressed.

A method for production of the encapsulant for optical semiconductor devices according to the present invention is not particularly limited, and examples thereof include a method in which the first organopolysiloxane, the second organopolysiloxane, the catalyst for hydrosilylation reaction, the organic compound A, and other components that are blended as necessary are mixed at ordinary temperature or under heating using a mixer such as HOMODISPER, a homomixer, a universal mixer, a planetarium mixer, a kneader, a three-roll mill, a bead mill or the like; and the like.

The light emitting element is not particularly limited as long as it is a light emitting element using a semiconductor, and for example, when the light emitting element is a light emitting diode, mention is made of, for example, a structure in which a semiconductor material for formation of a LED is stacked on a substrate. In this case, examples of the semiconductor material include GaAs, GaP, GaAlAs, GaAsP, AlGaInP, GaN, InN, AlN, InGaAlN, SiC and the like.

Examples of the material of the substrate include sapphire, spinel, SiC, Si, ZnO, GaN single crystals and the like. A buffer layer may be formed between the substrate and the semiconductor material as necessary. Examples of the material of the buffer layer include GaN, AlN and the like.

Specific examples of the optical semiconductor device according to the present invention include a light emitting diode device, a semiconductor laser device, a photocoupler and the like. These optical semiconductor devices can be suitably used for, for example, light sources for backlights of liquid crystal display panels and the like, illuminators, various kinds of sensors, printers, copiers and the like; light sources for vehicle instruments, signal lamps, indicator lamps, indicators and sheet-like light emitters; displays, ornaments, various kinds of lights, switching elements and the like.

In the optical semiconductor device according to the present invention, the light emitting element formed of an optical semiconductor is encapsulated by a cured product of the encapsulant for optical semiconductor devices according to the present invention. In the optical semiconductor device according to the present invention, the cured product of the encapsulant for optical semiconductor devices is placed so as to encapsulate the light emitting element formed of an optical semiconductor such as an LED. Thus, the adhesion between the package called a housing and the cured product of the encapsulant, and the bonding reliability with respect to humidity can be enhanced. Further, cracking is hard to occur in the cured product of the encapsulant for optical semiconductor devices, which encapsulates the light emitting element, detachment from the package is hard to occur, and the light permeability, heat resistance, weathering resistance and the gas barrier property can be enhanced.

### (Embodiment of optical semiconductor device)

Fig. 1 is a front sectional view showing an optical semiconductor device according to one embodiment of the present invention.

An optical semiconductor device 1 of this embodiment has a housing 2. An optical semiconductor element 3 as an LED is placed and mounted in the housing 2. An inner surface 2a of the housing 2, which has a light reflecting property, surrounds the periphery of the optical semiconductor element 3. In this embodiment, the optical semiconductor element 3 is used as a light emitting element formed of an optical semiconductor.

The inner surface 2a is formed such that the diameter of the inner surface 2a becomes larger gradually toward an open end. Therefore, light arriving at the inner surface 2a among light emitted from the optical semiconductor element 3 is reflected by the inner surface 2a, and travels to the front side of the optical semiconductor element 3. A region surrounded by the inner surface 2a is filled therein with an encapsulant 4 for optical semiconductor devices so as to encapsulate the optical semiconductor element 3. That is, the optical semiconductor element 3 is encapsulated by the encapsulant 4 for optical semiconductor devices in the housing 2.

In this embodiment, the encapsulant 4 for optical semiconductor devices has the aforementioned constitution, and is therefore capable of enhancing the adhesion at an interface P between the housing 2 and the encapsulant 4 for optical semiconductor devices, and capable of ensuring that cracking or detachment is hard to occur in the encapsulant even if the optical semiconductor device is used under a severe condition.

For enhancing the light reflecting property of the housing 2, titanium oxide may be contained in the housing 2. The encapsulant 4 for optical semiconductor devices contains an organic compound having a titanium atom, and is therefore capable of effectively enhancing the adhesion of the encapsulant 4 for optical semiconductor devices to a housing containing titanium oxide, and the bonding reliability with respect to humidity.

The structure shown in Fig. 1 is only one example of the optical semiconductor device according to the present invention, and the mount structure and the like of the optical semiconductor device can be appropriately modified.

The present invention will be described more in detail below by way of examples. The present invention is not limited to the examples below.

### (Synthesis Example 1) Synthesis of first organopolysiloxane

Into a 1000 mL separable flask equipped with a thermometer, a dropping device and a stirrer were added 63 g of trimethylmethoxysilane, 90 g of dimethyldimethoxysilane, 183 g of diphenyldimethoxysilane and 133 g of vinyltrimethoxysilane, and the mixture was stirred at 50°C. A solution obtained by dissolving 0.8 g of potassium hydroxide in 114 g of water was slowly added dropwise therein, and thereafter the mixture was stirred at 50°C for 6 hours and reacted to obtain a reaction liquid. Next, 0.9 g of acetic acid was added to the reaction liquid, the pressure was reduced to remove volatile components, and potassium acetate was removed by filtration to obtain a polymer (A).

The number average molecular weight (Mn) of the obtained polymer (A) was 1700. The chemical structure was identified by ²⁹Si-NMR, and resultantly it was found that the polymer (A) had the following average composition formula (A1).

(Me₃SiO_{1/2})_{0.19}(Me₂SiO_{2/2})_{0.24}(Ph₂SiO_{2/2})_{0.26}(ViSiO_{3/2})_{0.31} ...formula (A1)

In the above formula (A1), Me represents a methyl group, Ph represents a phenyl group, and Vi represents a vinyl group. The content ratio of the phenyl group in the obtained polymer (A) was 37 mol%.

The molecular weight of each polymer obtained in Synthesis Example 1 and Synthesis Examples 2 to 8 was determined by adding 1 mL of tetrahydrofuran to 10 mg of the polymer, stirring the mixture until the polymer was dissolved, and subjecting the solution to GPC measurement. In the GPC measurement, a measuring apparatus manufactured by Waters Corporation (column: two pieces of Shodex GPC LF-804 (length: 300 mm) manufactured by SHOWA DENKO K.K.; measurement temperature: 40°C; flow rate: 1 mL/minute; solvent: tetrahydrofuran; standard substance: polystyrene) was used.

### (Synthesis Example 2) Synthesis of first organopolysiloxane

Into a 1000 mL separable flask equipped with a thermometer, a dropping device and a stirrer were added 96 g of dimethyldimethoxysilane, 318 g of diphenyldimethoxysilane and 119 g of vinylmethyldimethoxysilane, and the mixture was stirred at 50°C. A solution obtained by dissolving 0.8 g of potassium hydroxide in 108 g of water was slowly added dropwise therein, and thereafter the mixture was stirred at 50°C for 6 hours and reacted to obtain a reaction liquid. Next, 0.9 g of acetic acid was added to the reaction liquid, the pressure was reduced to remove volatile components, and potassium acetate was removed by filtration to obtain a polymer (B).

The number average molecular weight (Mn) of the obtained polymer (B) was 5300. The chemical structure was identified by ²⁹Si-NMR, and resultantly it was found that the polymer (B) had the following average composition formula (B1).

(Me₂SiO_{2/2})_{0.25}(Ph₂SiO_{2/2})_{0.45}(ViMeSiO_{2/2})_{0.30} ...formula (B1)

In the above formula (B1), Me represents a methyl group, Ph represents a phenyl group, and Vi represents a vinyl group. The content ratio of the phenyl group in the obtained polymer (B) was 52 mol%.

### (Synthesis Example 3) Synthesis of first organopolysiloxane

Into a 1000 mL separable flask equipped with a thermometer, a dropping device and a stirrer were added 6.3 g of trimethylmethylmethoxysilane, 89 g of dimethyldimethoxysilane, 318 g of diphenyldimethoxysilane and 119 g of vinylmethyldimethoxysilane, and the mixture was stirred at 50°C. A solution obtained by dissolving 0.8 g of potassium hydroxide in 107 g of water was slowly added dropwise therein, and thereafter the mixture was stirred at 50°C for 6 hours and reacted to obtain a reaction liquid. Next, 0.9 g of acetic acid was added to the reaction liquid, the pressure was reduced to remove volatile components, and potassium acetate was removed by filtration to obtain a polymer (C).

The number average molecular weight (Mn) of the obtained polymer (C) was 5000. The chemical structure was identified by ²⁹Si-NMR, and resultantly it was found that the polymer (C) had the following average composition formula (C1).

(Me₃SiO_{1/2})_{0.01}(Me₂SiO_{2/2})_{0.24}(Ph₂SiO_{2/2})_{0.45}(ViMeSiO_{2/2})_{0.30} ...formula (C1)

In the above formula (C1), Me represents a methyl group, Ph represents a phenyl group, and Vi represents a vinyl group. The content ratio of the phenyl group in the obtained polymer (C) was 52 mol%.

### (Synthesis Example 4) Synthesis of second organopolysiloxane

Into a 1000 mL separable flask equipped with a thermometer, a dropping device and a stirrer were added 31 g of trimethylmethoxysilane, 50 g of 1,1,3,3-tetramethyldisiloxane, 108 g of dimethyldimethoxysilane and 208 g of phenyltrimethoxysilane, and the mixture was stirred at 50°C. A solution of 1.4 g of hydrochloric acid and 101 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (D) was obtained.

The number average molecular weight (Mn) of the obtained polymer (D) was 1000. The chemical structure was identified by ²⁹Si-NMR, and resultantly it was found that the polymer (D) had the following average composition formula (D1).

(Me₃SiO_{1/2})_{0.09}(HMe₂SiO_{1/2})_{0.23}(Me₂SiO_{2/2})_{0.27}(PhSiO_{3/2})_{0.41} ...formula (D1)

In the above formula (D1), Me represents a methyl group, and Ph represents a phenyl group. The content ratio of the phenyl group in the obtained polymer (D) was 33 mol%.

### (Synthesis Example 5) Synthesis of second organopolysiloxane

Into a 1000 mL separable flask equipped with a thermometer, a dropping device and a stirrer were added 16 g of trimethylmethoxysilane, 50 g of 1,1,3,3-tetramethyldisiloxane, 36 g of dimethyldimethoxysilane, 183 g of diphenyldimethoxysilane, 149 g of phenyltrimethoxysilane and 45 g of vinyltrimethoxysilane, and the mixture was stirred at 50°C. A solution of 1.4 g of hydrochloric acid and 104 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (E) was obtained.

The number average molecular weight (Mn) of the obtained polymer (E) was 1000. The chemical structure was identified by ²⁹Si-NMR, and resultantly it was found that the polymer (E) had the following average composition formula (E1).

(Me₃SiO_{1/2})_{0.05}(HMe₂SiO_{1/2})_{0.23}(Me₂SiO_{2/2})_{0.09}(Ph₂SiO_{2/2})_{0.26}(P hSiO_{3/2})_{0.27}(ViSiO_{3/2})_{0.10} ...formula (E1)

In the above formula (E1), Me represents a methyl group, Ph represents a phenyl group, and Vi represents a vinyl group. The content ratio of the phenyl group in the obtained polymer (E) was 51 mol%.

### (Synthesis Example 6) Synthesis of second organopolysiloxane

Into a 1000 mL separable flask equipped with a thermometer, a dropping device and a stirrer were added 31 g of trimethylmethoxysilane, 40 g of 1,1,3,3-tetramethyldisiloxane, 110 g of diphenyldimethoxysilane, 268 g of phenyltrimethoxysilane and 45 g of vinyltrimethoxysilane, and the mixture was stirred at 50°C. A solution of 1.4 g of hydrochloric acid and 116 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (F) was obtained.

The number average molecular weight (Mn) of the obtained polymer (F) was 1100. The chemical structure was identified by ²⁹Si-NMR, and resultantly it was found that the polymer (F) had the following average composition formula (F1).

(Me₃SiO_{1/2})_{0.09}(HMe₂SiO_{1/2})_{0.19}(Ph₂SiO_{2/2})_{0.16}(PhSiO_{3/2})_{0.46}(Vi SiO_{3/2})_{0.10} ...formula (F1)

In the above formula (F1), Me represents a methyl group, Ph represents a phenyl group, and Vi represents a vinyl group. The content ratio of the phenyl group in the obtained polymer (F) was 51 mol%.

### (Synthesis Example 7) Synthesis of first organopolysiloxane

Into a 1000 mL separable flask equipped with a thermometer, a dropping device and a stirrer were added 94 g of trimethylmethoxysilane, 99 g of dimethyldimethoxysilane, 92 g of diphenyldimethoxysilane and 133 g of vinyltrimethoxysilane, and the mixture was stirred at 50°C. A solution obtained by dissolving 0.8 g of potassium hydroxide in 108 g of water was slowly added dropwise therein, and thereafter the mixture was stirred at 50°C for 6 hours and reacted to obtain a reaction liquid. Next, 0.9 g of acetic acid was added to the reaction liquid, the pressure was reduced to remove volatile components, and potassium acetate was removed by filtration to obtain a polymer (G).

The number average molecular weight (Mn) of the obtained polymer (G) was 1800. The chemical structure was identified by ²⁹Si-NMR, and resultantly it was found that the polymer (G) had the following average composition formula (G1).

(Me₃SiO_{1/2})_{0.29}(Me₂SiO_{2/2})_{0.27}(Ph₂SiO_{2/2})_{0.13}(ViSiO_{3/2})_{0.31} ...formula (G1)

In the above formula (G1), Me represents a methyl group, Ph represents a phenyl group, and Vi represents a vinyl group. The content ratio of the phenyl group in the obtained polymer (G) was 21 mol%.

### (Synthesis Example 8) Synthesis of second organopolysiloxane

Into a 1000 mL separable flask equipped with a thermometer, a dropping device and a stirrer were added 31 g of trimethylmethoxysilane, 50 g of 1,1,3,3-hexamethyldisiloxane, 140 g of dimethyldimethoxysilane, 59 g of diphenyldimethoxysilane, 48 g of phenyltrimethoxysilane and 45 g of vinyltrimethoxysilane, and the mixture was stirred at 50°C. A solution of 1.4 g of hydrochloric acid and 92 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (H) was obtained.

The number average molecular weight (Mn) of the obtained polymer (H) was 600. The chemical structure was identified by ²⁹Si-NMR, and resultantly it was found that the polymer (H) had the following average composition formula (H1).

(Me₃SiO_{1/2})_{0.09}(HMe₂SiO_{1/2})_{0.24}(Me₂SiO_{2/2})_{0.38}(Ph₂SiO_{2/2})_{0.08}(P hSiO_{3/2})_{0.10}(ViSiO_{3/2})_{0.10} ...formula (H1)

In the above formula (H1), Me represents a methyl group, Ph represents a phenyl group, and Vi represents a vinyl group. The content ratio of the phenyl group in the obtained polymer (H) was 23 mol%.

### (Example 1)

The polymer A (10 g), the polymer D (10 g), a 1,3-divinyl-1,1,3,3-tetramethyldisiloxane complex of platinum (in such an amount that the content of the platinum element in the encapsulant was 10 ppm) and tetraisopropoxy titanium (0.05 g) were mixed, and the mixture was degassed to obtain an encapsulant for optical semiconductor devices.

### (Example 2)

The polymer A (10 g), the polymer D (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 3)

The polymer A (10 g), the polymer D (10 g), a 1,3-divinyl-1,1,3,3-tetramethyldisiloxane complex of platinum (in such an amount that the content of the platinum element in the encapsulant was 10 ppm), titanium isopropoxyoctylene glycolate (TOG manufactured by Nippon Soda Co., Ltd.; 0.05 g) and 3-glycidyloxypropyltrimethoxysilane (0.1 g) were mixed, and the mixture was degassed to obtain an encapsulant for optical semiconductor devices.

### (Example 4)

The polymer A (10 g), the polymer D (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and vinyltrimethoxysilane (0.1 g) were mixed, and the mixture was degassed to obtain an encapsulant for optical semiconductor devices.

### (Example 5)

The polymer B (10 g), the polymer D (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 6)

The polymer B (10 g), the polymer E (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 7)

The polymer C (10 g), the polymer D (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 8)

The polymer C (10 g), the polymer E (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 9)

The polymer C (10 g), the polymer F (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 3-glycidyloxypropyltrimethoxysilane (0.1 g) were mixed, and the mixture was degassed to obtain an encapsulant for optical semiconductor devices.

### (Example 10)

The polymer C (10 g), the polymer F (10 g), a 1,3-divinyl-1,1,3,3-tetramethyldisiloxane complex of platinum (in such an amount that the content of the platinum element in the encapsulant was 10 ppm), tetra-n-butoxy titanium (0.05 g) and 3-glycidyloxypropyltrimethoxysilane (0.1 g) were mixed, and the mixture was degassed to obtain an encapsulant for optical semiconductor devices.

### (Example 11)

The polymer C (10 g), the polymer F (10 g), a 1,3-divinyl-1,1,3,3-tetramethyldisiloxane complex of platinum (in such an amount that the content of the platinum element in the encapsulant was 10 ppm), tetrakis(2-ethylhexyloxy) titanium (0.05 g) and 3-glycidyloxypropyltrimethoxysilane (0.1 g) were mixed, and the mixture was degassed to obtain an encapsulant for optical semiconductor devices.

### (Example 12)

The polymer C (10 g), the polymer F (10 g), a 1,3-divinyl-1,1,3,3-tetramethyldisiloxane complex of platinum (in such an amount that the content of the platinum element in the encapsulant was 10 ppm), tetraisopropoxy titanium (0.05 g) and 2-(3,4-epoxycyclohexyl)ethyltrimethoxysilane (0.1 g) were mixed, and the mixture was degassed to obtain an encapsulant for optical semiconductor devices.

### (Example 13)

The polymer C (10 g), the polymer F (10 g), a 1,3-divinyl-1,1,3,3-tetramethyldisiloxane complex of platinum (in such an amount that the content of the platinum element in the encapsulant was 10 ppm), titanium isopropoxyoctylene glycolate (0.05 g) and 3-glycidyloxypropyltrimethoxysilane (0.1 g) were mixed, and the mixture was degassed to obtain an encapsulant for optical semiconductor devices.

### (Comparative Example 1)

The polymer G (10 g), the polymer D (10 g) and a 1,3-divinyl-1,1,3,3-tetramethyldisiloxane complex of platinum (in such an amount that the content of the platinum element in the encapsulant was 10 ppm) were mixed, and the mixture was degassed to obtain an encapsulant for optical semiconductor devices.

### (Comparative Example 2)

The polymer A (10 g), the polymer H (10 g) and a 1,3-divinyl-1,1,3,3-tetramethyldisiloxane complex of platinum (in such an amount that the content of the platinum element in the encapsulant was 10 ppm) were mixed, and the mixture was degassed to obtain an encapsulant for optical semiconductor devices.

### (Comparative Example 3)

The polymer A (10 g), the polymer D (10 g), a 1,3-divinyl-1,1,3,3-tetramethyldisiloxane complex of platinum (in such an amount that the content of the platinum element in the encapsulant was 20 ppm) and tetra-n-butoxy zirconium (0.05 g) were mixed, and the mixture was degassed to obtain an encapsulant for optical semiconductor devices.

### (Comparative Example 4)

The polymer A (10 g), the polymer D (10 g), a 1,3-divinyl-1,1,3,3-tetramethyldisiloxane complex of platinum (in such an amount that the content of the platinum element in the encapsulant was 20 ppm) and 3-glycidyloxypropyltrimethoxysilane (0.1 g) were mixed, and the mixture was degassed to obtain an encapsulant for optical semiconductor devices.

### (Evaluation)

### (Preparation of optical semiconductor device)

In a structure in which a light emitting element having a main light emission peak of 460 nm is mounted by a die bond material on a housing material made of polyphthalamide, which is provided with a lead electrode plated with silver, and the light emitting element and the lead electrode are connected to each other by a gold wire, the obtained encapsulant for optical semiconductor devices was injected, and cured by heating at 150°C for 2 hours to prepare an optical semiconductor device. This optical semiconductor device was used to conduct the initial adhesion test, humidity resistant adhesion test, gaseous corrosion test and heat shock test described below.

### (Initial adhesion test)

Twenty optical semiconductor devices obtained were immersed in a red ink, and left standing at 23°C for 8 hours. Thereafter, the optical semiconductor devices were taken out, and observed with a stereoscopic microscope ("SMZ-10" manufactured by NIKON CORPORATION) to check whether or not the red ink infiltrated at the interface between the housing material and the encapsulant, and the number of samples infiltrated with the red ink (NG number) was counted.

### (Humidity adhesion test)

Twenty optical semiconductor devices obtained were left standing under conditions of 121°C and 100 RH% to conduct a humidity resistant test. Twenty optical semiconductor devices were taken out after being left standing for 3 hours and 8 hours, respectively, and the optical semiconductor devices after the humidity resistant test were immersed in a red ink, and left standing at 23°C for 8 hours. Thereafter, the optical semiconductor devices were taken out, and observed with a stereoscopic microscope ("SMZ-10" manufactured by NIKON CORPORATION) to check whether or not the red ink infiltrated at the interface between the housing material and the encapsulant, and the number of samples infiltrated with the red ink (NG number) was counted.

### (Gaseous corrosion test)

The obtained optical semiconductor device was placed in a chamber under an atmosphere of 40°C and relative humidity of 90% RH, and the chamber was filled therein with a gas so that the concentration of hydrogen sulfide gas was 5 ppm and the concentration of sulfur dioxide gas was 15 ppm. After filling of the gas, lead electrodes plated with silver were visually observed after 24 hours, 48 hours, 96 hours, 168 hours and 500 hours, respectively.

Evaluations were made such that "oo" was assigned when the silver plate was not discolored, "o" was assigned when the silver plate was discolored dark brown at a small number of locations, "Δ" was assigned when the silver plate was almost entirely discolored brown, and "x" was assigned when the silver plate was almost entirely discolored black.

### (Heat shock test)

A cooling/heating cycle test having, as one cycle, a process of retaining the obtained optical semiconductor device at -50°C for 5 minutes, followed by elevating the temperature to 135°C, and retaining the optical semiconductor device at 135°C for 5 minutes, followed by lowering the temperature to 50°C was conducted using a liquid bath-type heat shock tester ("TSB-51" manufactured by ESPEC CORP.). Twenty samples were taken out after 500 cycles, 1000 cycles and 1500 cycles, respectively.

Samples were observed with a stereoscopic microscope ("SMZ-10" manufactured by NIKON CORPORATION). Observations were made to check whether or not cracking occurred in encapsulants for optical semiconductor devices or whether or not the encapsulant for optical semiconductor devices was detached from the package or the electrode for 20 samples, and the number of samples in which cracking or detachment occurred (NG number) was counted.

The results are shown in Table 1 below.

**[Table 1]**

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Initial adhesion test | | 0/20 | 0/20 | 0/20 | 0/20 | 0/20 | 0/20 | 0/20 | 0/20 | 0/20 | 0/20 |
| Humidity resistant adhesion test | After 3 hours | 0/20 | 0/20 | 0/20 | 0/20 | 0/20 | 0/20 | 0/20 | 0/20 | 0/20 | 0/20 |
| | After 8 hours | 8/20 | 0/20 | 4/20 | 2/20 | 0/20 | 0/20 | 0/20 | 0/20 | 0/20 | 0/20 |
| Gaseous corrosion test | After 24 hours | ○○ | ○○ | ○○ | ○○ | ○○ | ○○ | ○○ | ○○ | ○○ | ○○ |
| | After 48 hours | ○○ | ○○ | ○○ | ○○ | ○○ | ○○ | ○○ | ○○ | ○○ | ○○ |
| | After 96 hours | ○ | ○ | ○ | ○ | ○○ | ○○ | ○○ | ○○ | ○○ | ○○ |
| | After 168 hours | ○ | ○ | ○ | ○ | ○ | ○ | ○ | ○ | ○ | ○ |
| | After 500 hours | Δ | Δ | Δ | Δ | Δ | Δ | Δ | Δ | Δ | Δ |
| Heat shock test (NG number) | After 500 cycles | 0/20 | 0/20 | 0/20 | 0/20 | 0/20 | 0/20 | 0/20 | 0/20 | 0/20 | 0/20 |
| | After 1000 cycles | 0/20 | 0/20 | 0/20 | 0/20 | 0/20 | 0/20 | 0/20 | 0/20 | 0/20 | 0/20 |
| | After 1500 cycles | 2/20 | 2/20 | 2/20 | 2/20 | 0/20 | 0/20 | 0/20 | 0/20 | 0/20 | 0/20 |
| | | | | | | | | | | | |

| | | Example 11 | Example 12 | Example 13 | Comparative Example 1 | Comparative Example 2 | Comparative Example 3 | Comparative Example 4 | | | |
|---|---|---|---|---|---|---|---|---|---|---|---|
| Initial adhesion test | | 0/20 | 0/20 | 0/20 | 3/20 | 4/20 | 2/20 | 3/20 | | | |
| Humidity resistant adhesion test | After 3 hours | 0/20 | 0/20 | 0/20 | 15/20 | 16/20 | 8/20 | 14/20 | | | |
| | After 8 hours | 0/20 | 0/20 | 0/20 | 20/20 | 20/20 | 15/20 | 18/20 | | | |
| Gaseous corrosion test | After 24 hours | ○○ | ○○ | ○○ | ○ | ○ | ○○ | ○○ | | | |
| | After 48 hours | ○○ | ○○ | ○○ | Δ | Δ | ○○ | ○○ | | | |
| | After 96 hours | ○○ | ○○ | ○○ | Δ | Δ | ○ | ○ | | | |
| | After 168 hours | ○ | ○ | ○ | × | × | ○ | ○ | | | |
| | After 500 hours | Δ | Δ | Δ | × | × | Δ | Δ | | | |
| Heat shock test (NG number) | After 500 cycles | 0/20 | 0/20 | 0/20 | 0/20 | 0/20 | 0/20 | 0/20 | | | |
| | After 1000 cycles | 0/20 | 0/20 | 0/20 | 4/20 | 0/20 | 0/20 | 0/20 | | | |
| | After 1500 cycles | 0/20 | 0/20 | 0/20 | 9/20 | 3/20 | 3/20 | 4/20 | | | |

### EXPLANATION OF SYMBOLS

1: Optical semiconductor device
2: Housing
2a: Inner surface
3: Optical semiconductor element
4: Encapsulant for optical semiconductor devices
P: Interface between housing and encapsulant

## Claims

1. An encapsulant for optical semiconductor devices comprising:
a first organopolysiloxane having an alkenyl group bonded to a silicon atom and an aryl group bonded to a silicon atom, but not having a hydrogen atom bonded to a silicon atom;
a second organopolysiloxane having a hydrogen atom bonded to a silicon atom and an aryl group bonded to a silicon atom;
a catalyst for hydrosilylation reaction; and
an organic compound having a titanium atom.

2. The encapsulant for optical semiconductor devices according to claim 1,
wherein the organic compound having a titanium atom is tetraisopropoxy titanium, tetra-n-butoxy titanium, tetrakis(2-ethylhexyloxy) titanium or titanium isopropoxyoctylene glycolate.

3. The encapsulant for optical semiconductor devices according to claim 1, further comprising an alkoxysilane compound.

4. The encapsulant for optical semiconductor devices according to claim 2, further comprising an alkoxysilane compound.

5. The encapsulant for optical semiconductor devices according to claim 3,
wherein the alkoxysilane compound is 3-glycidyloxypropyl trimethoxysilane or 2-(3,4-epoxycyclohexyl)ethyl trimethoxysilane.

6. The encapsulant for optical semiconductor devices according to claim 4,
wherein the alkoxysilane compound is 3-glycidyloxypropyl trimethoxysilane or 2-(3,4-epoxycyclohexyl)ethyl trimethoxysilane.

7. The encapsulant for optical semiconductor devices according to any one of claims 1 to 6,
wherein the first organopolysiloxane is a first organopolysiloxane represented by the following formula (1A), the second organopolysiloxane is a second organopolysiloxane represented by the following formula (51A), and the content ratios of the aryl groups determined from the following formula (X) in the first organopolysiloxane and the second organopolysiloxane each are 30 mol% or more and 70 mol% or less:
[Formula 1]
**(R1R2R3SiO_{1/2})ₐ(R4R5SiO_{2/2})_{c}** **··· Formula (1A)**
wherein, a, b and c satisfy a / (a + b + c) = 0 to 0.50, b / (a + b + c) = 0.40 to 1.0 and c / (a + b + c) = 0 to 0.50, at least one of R1 to R6 represents a phenyl group, at least one of R1 to R6 represents an alkenyl group, and R1 to R6 other than phenyl and alkenyl groups represent a hydrocarbon group having 1 to 8 carbon atoms;
[Formula 2]
**(R51R52R53SiO_{1/2})ₚ(R54R55SiO_{2/2})_{q}(R56SiO_{3/2})ᵣ** **··· Formula (51A)**
wherein, p, q and r satisfy p / (p + q + r) = 0.05 to 0.50, q / (p + q + r) = 0.05 to 0.50 and r / (p + q + r) = 0.20 to 0.80, at least one of R51 to R56 represents a phenyl group, at least one of R51 to R56 represents a hydrogen atom bonded directly to a silicon atom, and R51 to R56 other than a phenyl group and a hydrogen group bonded directly to a silicon atom represent a hydrocarbon group having 1 to 8 carbon atoms;
content ratio of aryl groups (mol%) = (average number of aryl groups contained per molecule of the first organopolysiloxane or the second organopolysiloxane × molecular weight of aryl group / number average molecular weight of the first organopolysiloxane or the second organopolysiloxane) × 100 ...formula (X).

8. An optical semiconductor device comprising:
a housing;
an optical semiconductor element placed in the housing; and
the encapsulant for optical semiconductor devices according to any one of claims 1 to 6, which is provided to encapsulate the optical semiconductor element in the housing.

9. An optical semiconductor device comprising:
a housing;
an optical semiconductor element placed in the housing; and
the encapsulant for optical semiconductor devices according to claim 7, which is provided to encapsulate the optical semiconductor element in the housing.
